# EUROPEAN PATENT APPLICATION

(11) **EP 4 432 478 A1**
(43) Date of publication of application: **18.09.2024**
(21) Application number: 22891517.9
(22) Date of filing: 26.07.2022
(51) Int. Cl.: H01R 13/02, H01R 13/648, H01R 12/71

(54) **CABLE CONNECTOR, CABLE CONNECTOR ASSEMBLY, AND ELECTRONIC DEVICE**

(30) Priority: 11.11.2021 CN 202111332113
(71) Applicant: Huawei Technologies Co., Ltd., Shenzhen, Guangdong 518129 (CN)
(72) Inventor: ZHAO, Zhigang, Shenzhen, Guangdong 518129 (CN); ZENG, Tao, Shenzhen, Guangdong 518129 (CN); YANG, Jian, Shenzhen, Guangdong 518129 (CN)
(74) Representative: Körber, Martin Hans
(86) International application number: PCT/CN2022/108033
(87) International publication number: WO 2023/082708

(57) **Abstract**

Embodiments of this application provide a cable connector, a cable connector assembly, and an electronic device. The cable connector includes a plurality of signal pair units that are disposed at intervals. Each signal pair unit includes two signal terminals that are disposed in parallel. A first end of each signal terminal is configured to be in electrical contact with a corresponding pin on a circuit board. A second end of each signal terminal is configured to electrically connect to a corresponding cable. A bent portion is formed on each signal terminal in an extension direction of the signal terminal. There is a specific distance between the bent portion and the first end. An extension length of the bent portion may be increased, so that an end of the signal terminal can be stably pressed against a corresponding pin on the circuit board, to ensure reliability of an electrical connection between the cable connector and the circuit board without occupying surface space of a mating surface used by the circuit board to contact the signal terminal.

## Description

This application claims priority to Chinese Patent Application No. 202111332113.8, filed with the China National Intellectual Property Administration on November 11, 2021 and entitled "CABLE CONNECTOR, CABLE CONNECTOR ASSEMBLY, AND ELECTRONIC DEVICE", which is incorporated herein by reference in its entirety.

### TECHNICAL FIELD

Embodiments of this application relate to the field of cable connector technologies, and in particular, to a cable connector, a cable connector assembly, a circuit board assembly, and an electronic device.

### BACKGROUND

As a mainstream link of a serial-to-parallel conversion circuit (SERializer DESerializer, Serdes for short) of a communication device evolves to a rate of 112G+ or a higher rate, a high-speed link has an increasingly strict requirement on a link loss, and a wiring loss on a circuit board such as a printed circuit board (Print Circuit Board, PCB for short) is obviously higher than that on a high-speed cable (cable). Therefore, more and more designs are to replace conventional circuit board wiring with cable wiring.

Currently, a circuit board is electrically connected to a cable connector, and one end of a cable is electrically connected to the cable connector, so that the cable is led out from the circuit board, to electrically connect to an external circuit or component by the cable. The cable connector is provided with a signal terminal, a head of the signal terminal is in electrical contact with a pin such as a pad on the circuit board, and a tail of the signal terminal is electrically connected to one end of the cable, so that the cable is electrically connected to the pin on the circuit board by the signal terminal. In the related art, a portion that is close to the head of the signal terminal is a bent portion, and the bent portion extends along a surface of the circuit board, to ensure that when the cable connector is assembled on the circuit board, the bent portion is squeezed, so that the head of the signal terminal is closely pressed against the pin under a pre-tightening force.

However, in the cable connector, the head of the signal terminal cannot be stably pressed against the corresponding pin on the circuit board.

### SUMMARY

Embodiments of this application provide a cable connector, a cable connector assembly, a circuit board assembly, and an electronic device. One end of the cable connector can be stably pressed against a corresponding pin on a circuit board, to ensure reliability of an electrical connection between the cable connector and the circuit board.

According to an aspect, an embodiment of this application provides a cable connector, including a plurality of signal pair units that are disposed at intervals;
each signal pair unit includes two signal terminals that are disposed in parallel, a first end of each signal terminal is configured to be in electrical contact with a corresponding pin on a circuit board, and a second end of each signal terminal is configured to electrically connect to a corresponding cable; and
a bent portion is formed on each signal terminal in an extension direction of the signal terminal, and there is a specific distance between the bent portion and the first end.

According to the cable connector provided in this embodiment of this application, in the signal pair unit, the bent portion of the signal terminal is disposed at the specific distance from the first end of the signal terminal. In other words, the bent portion of the signal terminal is adjusted by a distance in a direction toward the second end, so that a portion of the signal terminal close to the first end is consistent with a main extension direction of the signal terminal, that is, there is no bent portion in another direction. In this way, when the cable connector is assembled on the circuit board, the first end of the signal terminal and the portion close to the first end may be disposed perpendicular to the circuit board, to avoid that the portion close to the first end of the signal terminal occupies space of the circuit board in a pin arrangement direction. An extension length of the bent portion in a direction perpendicular to the main extension direction of the signal terminal may be increased, to improve elasticity of the signal terminal in the extension direction, and ensure reliability of contact between the first end of the signal terminal and the pin on the circuit board. Surface space of the circuit board for contacting a mating surface of the signal terminal is not occupied. In this way, a spacing between adjacent signal terminals in the cable connector can be reduced, so that the cable connector forms a high-speed high-density cable connector, and the cable connector is applicable to a circuit board with high-density pins.

In addition, the signal terminal in the signal pair unit is disposed to have the foregoing structure, so that when the first end of the signal terminal is pressed against and cooperates with the pin on the circuit board, a compression process in a direction perpendicular to the circuit board occurs, and the first end does not slide in a direction parallel to the circuit board, that is, does not slide on the mating surface. In this way, contact stability between the first end of the signal terminal and the pin on the circuit board can be ensured. In this way, when the signal terminal is electrically connected to the pin through a pad, a cross-sectional size of the pad can be reduced, to ensure that impedance between the signal terminal and the pin is stable. In addition, the signal terminal in this embodiment of this application does not need to occupy a size of the mating surface, so that appropriate space is provided for a shielding member of the cable connector, a reference ground of the circuit board, and a connection structure between the two, to ensure a shielding function of the first end of the signal terminal, and improve anti-crosstalk performance of the signal terminal. In addition, in the related art, an arc hook is disposed at the first end of the signal terminal, to avoid damage to the pad on the pin when the signal terminal slides along the mating surface. Compared with the related art, in this embodiment of this application, the portion of the signal terminal close to the first end does not have a bent portion, the first end of the signal terminal is perpendicularly pressed against the pin such as the pad of the circuit board, and there is no sliding trend along the mating surface. Therefore, the first end of the signal terminal has no hook, a signal loss at the first end of the signal terminal is reduced, and performance of transmitting a high-speed signal by the signal pair unit is ensured.

In a feasible implementation, the bent portion is provided with a plurality of portions in the extension direction of the signal terminal. In the plurality of portions, two adjacent portions have different bending directions. In this way, elasticity of the bent portion in the extension direction of the signal terminal can be enhanced, so that the first end of the signal terminal can be stably pressed against the pin on the circuit board, and it can be ensured that the bent portion does not occupy a horizontal size of the mating surface between the cable connector and the circuit board.

In a feasible implementation, the cable connector further includes a conductive housing, and the conductive housing is configured to electrically connect to a reference ground of the circuit board; and
the conductive housing is provided with a plurality of shielding cavities that are provided at intervals, the plurality of shielding cavities are provided corresponding to the plurality of signal pair units, each signal pair unit is at least partially located in a corresponding shielding cavity, and the signal pair unit is insulated from an inner wall of the shielding cavity.

In this embodiment of this application, the conductive housing is disposed in the cable connector, and the shielding cavities that are independent of each other are provided in the conductive housing. In this way, each signal pair unit is accommodated in a corresponding shielding cavity, and the conductive housing is electrically connected to the reference ground of the circuit board, so that the conductive housing has a function of shielding against a signal, to effectively keep the signal pair units from radiating high-speed signal waves to the outside and affecting signal transmission stability of each other. Therefore, anti-crosstalk performance of the signal pair units in the cable connector is improved.

In a feasible implementation, a distance between the bent portion and the inner wall of the corresponding shielding cavity is equal in an extension direction of the bent portion, to ensure that characteristic impedance of the bent portion is consistent in the extension direction, so that performance of the cable connector in transmitting a high-speed signal is improved.

In a feasible implementation, the conductive housing is provided with a plurality of first avoidance openings at one end, and the plurality of first avoidance openings are provided corresponding to the plurality of shielding cavities; and each first avoidance opening is connected to the corresponding shielding cavity, and each first avoidance opening is configured to allow the first end of the corresponding signal terminal to penetrate out of the shielding cavity, so that the first end of the signal terminal is in electrical contact with the pin on the circuit board.

In a feasible implementation, the cable connector further includes a plurality of first insulating members, and the plurality of first insulating members are disposed corresponding to the plurality of signal pair units; and
each first insulating member is disposed between the corresponding signal terminal and an inner wall of the first avoidance opening.

In this embodiment of this application, the first insulating member is disposed between each signal terminal and the inner wall of the first avoidance opening, to fasten each signal terminal, and ensure that the first end of the signal terminal can be stably pressed against the pin on the circuit board. In addition, the first insulating member is disposed to ensure effective insulation between the first end of the signal terminal and the conductive housing, keep the signal terminal from being short-circuited, and keep the signal terminal from shaking in a direction parallel to the mating surface to contact the conductive housing.

In a feasible implementation, the cable connector further includes a plurality of second insulating members, and the plurality of second insulating members are disposed corresponding to the plurality of signal pair units; and
each second insulating member is disposed between the corresponding signal pair unit and the inner wall of the shielding cavity, and each second insulating member is disposed close to the second end of the signal terminal.

In this embodiment of this application, the second insulating member is disposed at a position of the signal terminal close to the second end, and the second insulating member is disposed between the signal pair unit and the inner wall of the shielding cavity, to ensure effective insulation between each signal terminal of the signal pair unit and the conductive housing, and avoid a short circuit between the signal terminal and the conductive housing. In addition, the second insulating member is disposed to improve stability of the signal pair unit in the shielding cavity, and keep the signal pair unit from shaking in an extension direction perpendicular to the signal terminal, to improve electrical contact stability between the signal terminal of the signal pair unit and the pin on the circuit board, and keep the signal terminal from contacting the conductive housing in a shaking process.

In a feasible implementation, a connection between the second end of the signal terminal and the cable is located in the shielding cavity, and the second insulating member is at least partially located between the connection and the inner wall of the shielding cavity, to protect a connection between the cable and the signal terminal. For example, when the cable is connected to the signal terminal in a soldering manner, the second insulating member may protect a solder joint, to avoid a case such as a break at the solder joint.

In a feasible implementation, each cable is at least partially located in the corresponding shielding cavity;
each cable includes a cable core, an insulating layer, and a conductive layer that are sequentially sleeved from inside out; and
the cable connector further includes a conductive medium, where the conductive medium is filled between the conductive layer and the inner wall of the shielding cavity.

In this embodiment of this application, the conductive medium is filled between the conductive layer of the cable and the shielding cavity. In one aspect, the conductive layer of the cable may be electrically connected to the conductive housing. In this way, when the conductive housing is electrically connected to the reference ground of the circuit board, the conductive layer of the cable, the conductive housing, and the reference ground of the circuit board form a good ground return current system, to improve an external shielding function of the cable connector and the cable, avoid mutual crosstalk between the cable connector and the cable and an external signal, and also avoid signal crosstalk between the signal pair units inside the cable connector.

In a feasible implementation, the cable connector further includes a ground contact member;
the ground contact member is disposed on a side of the conductive housing close to the first end of the signal terminal, one side of the ground contact member is electrically connected to the conductive housing, and the other side of the ground contact member is configured to electrically connect to the reference ground of the circuit board; and
the ground contact member is provided with a plurality of second avoidance openings, and each second avoidance opening is configured to allow the corresponding signal terminal to pass through.

In this embodiment of this application, a ground contact member is disposed on a side of the conductive housing close to the first end of the signal terminal, so that the conductive housing is electrically connected to the reference ground of the circuit board by the ground contact member, to ensure a signal shielding effect of the conductive housing.

In a feasible implementation, an elastic member is provided on the ground contact member, and an elastic direction of the elastic member is consistent with the extension direction of the signal terminal. In this way, when the cable connector is electrically connected to the circuit board, the ground contact member may be squeezed by the conductive housing and the circuit board, so that the ground contact member can be in close electrical contact with the reference ground of the circuit board under a pre-tightening force of the elastic member, to ensure a reliable electrical connection between the conductive housing and the reference ground of the circuit board.

In a feasible implementation, the elastic member is configured as an elastic arm, an extension direction of the elastic arm is perpendicular to the extension direction of the signal terminal, one end of the elastic arm is connected to the ground contact member, and the other end of the elastic arm is configured to electrically connect to the reference ground of the circuit board.

The elastic member is disposed as the elastic arm. In one aspect, tightness of electrical contact between the ground contact member and the reference ground of the circuit board is ensured. In another aspect, the elastic arm is disposed to improve stability of a connection between the elastic member and the ground contact member, and also simplify a structure of the elastic member.

In a feasible implementation, the elastic arm is at least partially disposed in the first avoidance opening, to appropriately use space in the second avoidance opening. This avoids that the elastic arm occupies a space size of a side of the ground contact member opposite to the conductive housing, that is, the mating surface, and avoids that the elastic arm causes interference to the signal terminal, to avoid affecting electrical contact between the signal terminal and the pin on the circuit board.

In a feasible implementation, the ground contact member is configured as an elastic buffer. In this way, when the cable connector is electrically connected to the circuit board, the ground contact member is compressed by using an elastic function of the ground contact member, so that the ground contact member generates an elastic force perpendicular to the circuit board, to ensure that the ground contact member is in close contact with the reference ground of the circuit board, and ensure reliable grounding of the conductive housing.

In a feasible implementation, a convex rib is provided on a side of the conductive housing facing the ground contact member, and the convex rib is pressed against the ground contact member.

The convex rib is disposed on the side of the conductive housing facing the ground contact member, so that when the cable connector is assembled with the circuit board, the convex rib can squeeze the ground contact member, to increase a compression amount of an elastic material at a corresponding position of the ground contact member. In this way, contact between a position of the convex rib corresponding to the ground contact member and the reference ground of the circuit board is closer.

In a feasible implementation, the conductive housing is further provided with an accommodating groove, the accommodating groove is located in a side of all the shielding cavities opposite to the first avoidance opening, and each cable is further partially located in the accommodating groove;
the cable connector further includes a thrust member, the thrust member is disposed in the accommodating groove, and an outer edge of the thrust member is connected to an inner wall of the accommodating groove; and
the thrust member is provided with a plurality of third avoidance openings, each third avoidance opening is configured to allow a corresponding cable to pass through, and a width of each third avoidance opening is less than a cross-sectional size of each signal terminal. In this way, the thrust member can be used to stop the signal terminal in the conductive housing, to keep the signal terminal from loosening in the shielding cavity, so that the signal terminal is kept from being detached from the shielding cavity.

According to another aspect, an embodiment of this application further provides a cable connector assembly, including a plurality of cables and the foregoing cable connector.
in the cable connector, each signal terminal of a signal pair unit is electrically connected to a corresponding cable.

In this embodiment of this application, the cable connector is disposed in the cable connector assembly. An extension length of a bent portion in the signal terminal in a direction perpendicular to a main extension direction of the main extension direction of the signal terminal is adjusted, to improve elasticity of the signal terminal in the main extension direction, and ensure reliable contact between a first end of the signal terminal and a pin on the circuit board, so that a reliable electrical connection between the cable connector assembly and the pin on the circuit board is ensured. In addition, the signal terminal in the cable connector assembly does not occupy surface space of the circuit board for contacting a mating surface of the signal terminal. In this way, the cable connector is applicable to a circuit board with high-density pins.

In a feasible implementation, the cable includes a cable core, an insulating layer, and a conductive layer that are sequentially disposed from inside out; and

one end of the cable core is electrically connected to a corresponding signal terminal, and the conductive layer is electrically connected to a conductive housing of the cable connector.

In this embodiment of this application, the conductive layer of the cable is electrically connected to the conductive housing. When the conductive housing is electrically connected to the reference ground of the circuit board, the conductive layer of the cable, the conductive housing, and the reference ground of the circuit board form a good ground return current system, to improve an external shielding function of the cable connector assembly, avoid mutual crosstalk between the cable connector and the cable and an external signal, and also avoid signal crosstalk between the signal pair units inside the cable connector.

In a feasible implementation, the cable further includes a cable insulator; and
the cable insulator is disposed on a periphery of one end of the cable core connected to the signal terminal, so that one end of the cable core is separated from an inner side wall of the conductive housing by using the cable insulator, to avoid a short circuit caused by electrical contact between a connection such as a solder joint between the cable core and the signal terminal and an inner wall of the conductive housing.

According to still another aspect, an embodiment of this application further provides a circuit board assembly, including a circuit board and the foregoing cable connector assembly, where
a signal terminal of the cable connector assembly is in electrical contact with a corresponding pin on the circuit board, and a first end of the signal terminal is at least partially perpendicular to the circuit board.

In this embodiment of this application, the cable connector assembly is disposed in the circuit board assembly, so that a portion of the signal terminal close to the first end in the cable connector assembly does not occupy space of the circuit board in a pin arrangement direction. An extension length of a bent portion in a direction perpendicular to a main extension direction of the main extension direction of the signal terminal may be adjusted, to improve elasticity of the signal terminal in the main extension direction, and ensure reliable contact between the first end of the signal terminal and a pin on the circuit board, so that a reliable electrical connection between the cable and the pin on the circuit board is ensured. The portion of the signal terminal close to the first end does not occupy surface space of a mating surface of the circuit board, so that the cable connector is applicable to a circuit board with high-density pins, to ensure signal transmission performance of a high-density circuit board assembly.

In a feasible implementation, a pad is provided on a pin on the circuit board, and one end of the signal terminal is in electrical contact with the pad, to increase an electrical contact area between the signal terminal and the pin, so that electrical contact between the signal terminal and the pin is more reliable.

In a feasible implementation, the pad is provided with a groove, and the first end of the signal terminal is located in the groove.

The groove is provided in the pad, and the first end of the signal terminal is disposed in the groove, to limit movement of the first end of the signal terminal on a surface of the pad, and ensure contact stability of the first end of the signal terminal on the pad, so that impedance stability of the first end of the signal terminal is ensured. For example, when the groove is provided at the center of the pad, the first end of the signal terminal may be limited at the center of the pad, to ensure that high-speed transmission performance of the signal terminal is more stable.

In a feasible implementation, the circuit board includes any one of a substrate and a chip. For example, the signal terminal of the cable connector assembly may be electrically connected to a pin on the substrate, or may be electrically connected to a pin on the chip. In other words, the substrate may be electrically connected to a cable by the cable connector in this embodiment of this application, to improve contact stability between the pin on the substrate and the signal terminal in the cable connector, and the signal terminal does not occupy space on a surface of the substrate, so that the cable connector is applicable to a high-density substrate. Correspondingly, the chip may also be electrically connected to the cable by the cable connector in this embodiment of this application, to improve contact stability between a pin on the chip and a signal terminal in the cable connector, and the signal terminal does not occupy surface space of the chip for contacting a mating surface of the signal terminal, so that the cable connector is applicable to a high-density chip.

### BRIEF DESCRIPTION OF DRAWINGS

FIG. 1 is a schematic diagram of a structure of a circuit board assembly according to an embodiment of this application;
FIG. 2 is a schematic diagram of a structure of a circuit board in FIG. 1;
FIG. 3 is an assembly diagram of a cable connector assembly and a part of a substrate in FIG. 1;
FIG. 4 is a schematic diagram of a structure of the cable connector assembly in FIG. 3;
FIG. 5 is a schematic diagram of a partial structure of the substrate in FIG. 3;
FIG. 6 is a partial enlarged view of I in FIG. 5;
FIG. 7 is a schematic diagram of a structure of a signal pair unit and a cable in FIG. 4;
FIG. 8 is a schematic diagram of a partial structure in FIG. 4;
FIG. 9 is a partial enlarged view of II in FIG. 8;
FIG. 10 is a partial enlarged view of III in FIG. 9;
FIG. 11 is a schematic diagram of a partial structure of a cable connector in the related art;
FIG. 12 is a right view of FIG. 8;
FIG. 13 is an assembly diagram of a part of the cable connector assembly and the substrate in FIG. 4;
FIG. 14 is a schematic diagram of a structure of a signal pair unit and a cable in FIG. 4;
FIG. 15 is a schematic diagram of a structure of a conductive housing in FIG. 4;
FIG. 16 is a cross-sectional view of FIG. 15 along A-A;
FIG. 17 is a bottom view of FIG. 15;
FIG. 18 is a cross-sectional view of FIG. 3 along B-B;
FIG. 19 is a partial enlarged view of IV in FIG. 18;
FIG. 20 is an assembly diagram of a conductive housing and a cable in FIG. 4;
FIG. 21 is a partial enlarged view of V in FIG. 20;
FIG. 22 is a top view of FIG. 19;
FIG. 23 is a partial exploded view of FIG. 4;
FIG. 24 is a schematic diagram of a structure of a thrust member shown in FIG. 23;
FIG. 25 is a schematic diagram of a structure of a cable connector in FIG. 4;
FIG. 26 is a partial enlarged view of VI in FIG. 25;
FIG. 27 is a schematic diagram of a structure of a ground contact member shown in FIG. 25;
FIG. 28 is a partial enlarged view of VII in FIG. 27;
FIG. 29 is a schematic diagram of another structure of a ground contact member shown in FIG. 4;
FIG. 30 is an assembly diagram of another conductive housing and a cable in FIG. 4;
FIG. 31 is a partial enlarged view of VIII in FIG. 30;
FIG. 32 is a schematic diagram of a structure of the substrate and a signal terminal in FIG. 18; and
FIG. 33 is a schematic diagram of a structure of the substrate in FIG. 32.

### Reference numerals:

100: Circuit board; 200: Cable connector assembly;
100a: Lead region; 110: Substrate; 120: Chip; 210, 1: Cable connector; 220: Cable;
110a: Unit pad region; 111: Pad; 112: Mating surface; 211: Signal pair unit; 212: Conductive housing; 213: Screw hole; 214: Conductive medium; 215: First insulating member; 216: Second insulating member; 217: Thrust member; 218: Ground contact member; 219: Fixing adhesive; 221: Cable core; 222: Insulation layer; 223: Conductive layer; 224: Cable insulator;
1111: Groove; 2111, 11: Signal terminal; 211a: First main body portion; 211b, 11b: Bent portion; 211c: Second main body portion; 2121: Shielding cavity; 2122: First avoidance opening; 2123: Accommodating groove; 2124: Mounting groove; 2125: Convex rib; 2171: Third avoidance opening; 218a: Second avoidance opening; 218b: Mounting hole; 2181: Elastic member; and
11a: Main body portion; and 11c: Hook.

### DESCRIPTION OF EMBODIMENTS

Terms used in embodiments of this application are only used to explain specific embodiments of this application, but are not intended to limit this application.

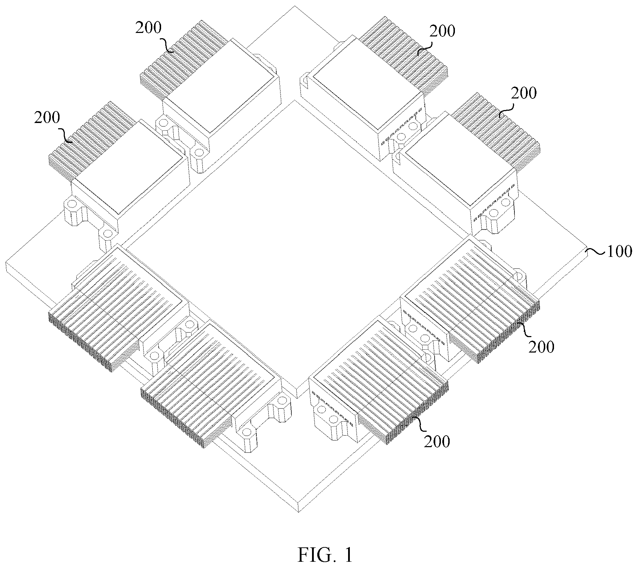

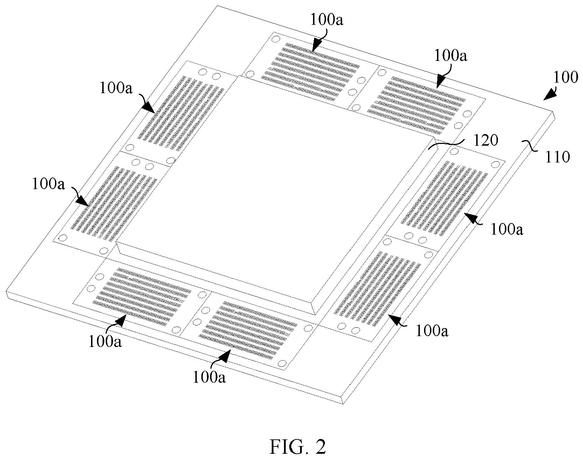

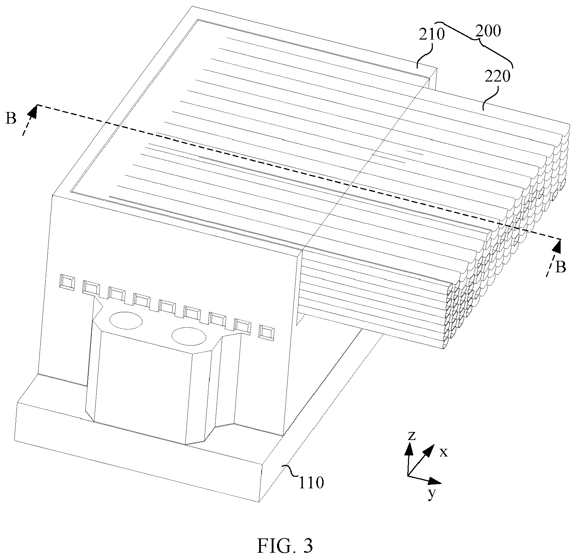

FIG. 1 is a schematic diagram of a structure of a circuit board assembly according to an embodiment of this application. FIG. 2 is a schematic diagram of a structure of a circuit board in FIG. 1. FIG. 3 is an assembly diagram of a cable connector assembly and a part of a substrate in FIG. 1.

An embodiment of this application provides an electronic device, including a circuit board assembly (as shown in FIG. 1).

It should be noted that the electronic device in this embodiment of this application may include, but is not limited to, a fixed terminal or a mobile terminal having a circuit board assembly, for example, a mobile phone, a tablet computer, a notebook computer, an ultra-mobile personal computer (ultra-mobile personal computer, UMPC), a handheld computer, a touch television, an intercom, a netbook, a POS machine, a personal digital assistant (personal digital assistant, PDA), a wearable device, or a virtual reality device.

The electronic device provided in this embodiment of this application may be an electronic device having a network communication function. A mainstream Serdes link inside the electronic device evolves to a rate of 112G+ or a higher rate, and a high-speed link has an increasingly strict requirement on a link loss. Based on this, referring to FIG. 1 to FIG. 3, a plurality of cables 220, for example, thousands of cables 220, are led out from any lead region 100a of the circuit board assembly. One component, for example, a controller, in the electronic device is electrically connected to the circuit board assembly by the thousands of cables 220, so that an internal running rate of the electronic device is higher. In addition, the cables 220 are led out from the circuit board assembly, and the component is electrically connected to a circuit board 100 in the circuit board assembly by the cables 220. Compared with that a wiring layer is directly disposed on the circuit board 100 and a component is directly electrically connected to the wiring layer of the circuit board 100. This reduces a loss on a high-speed link between the component and the circuit board 100.

Referring to FIG. 2 and FIG. 3, specifically, the circuit board assembly provided in this embodiment of this application includes a circuit board 100 and at least one cable connector assembly 200.

Referring to FIG. 2, the circuit board 100 is provided with a plurality of lead regions 100a, and there may be a plurality of cable connector assemblies 200 (referring to FIG. 1). The plurality of cable connector assemblies 200 may be disposed in a one-to-one correspondence with the plurality of lead regions 100a, and each cable connector assembly 200 is electrically connected to a pin in each lead region 100a, so that the cable 220 is led out from each lead region 100a (referring to FIG. 1 to FIG. 3).

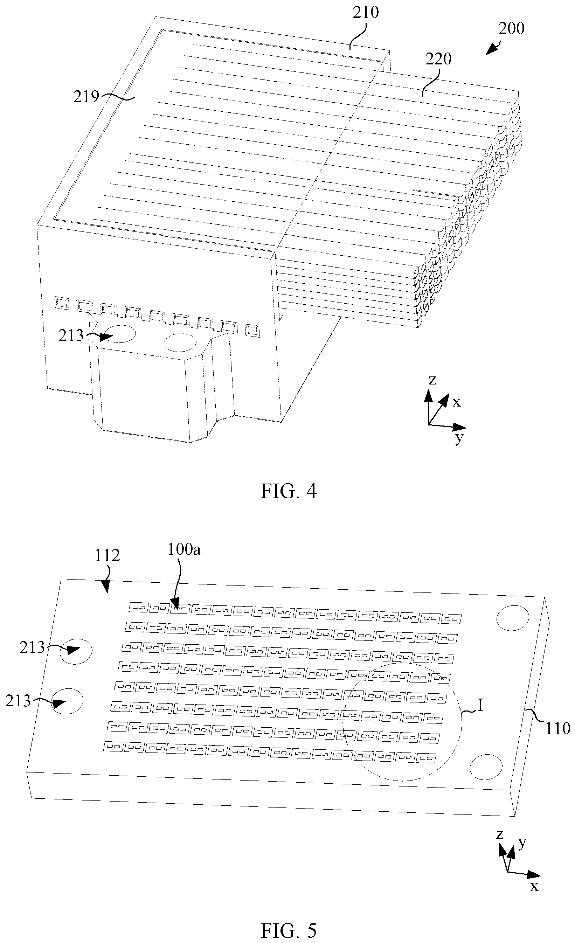

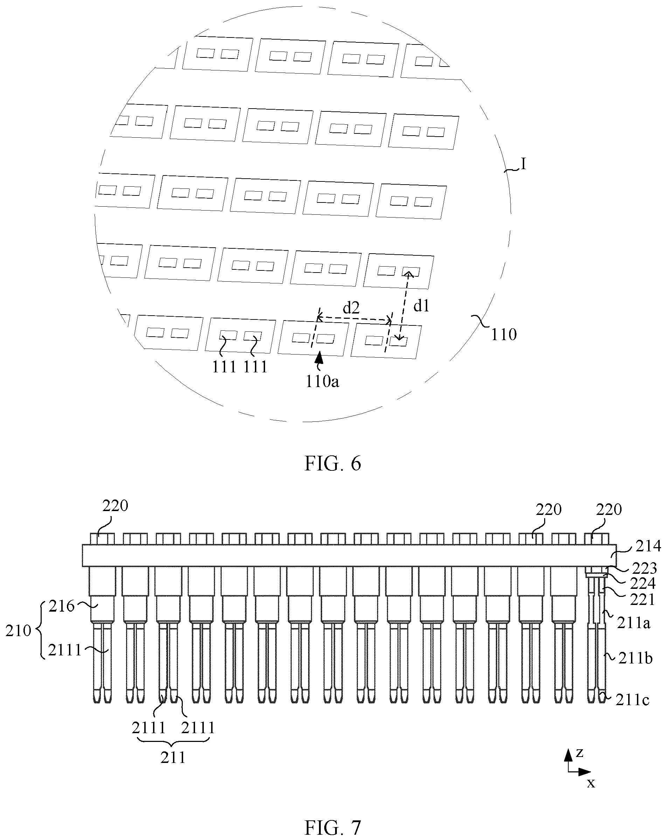

FIG. 4 is a schematic diagram of a structure of the cable connector assembly in FIG. 3. FIG. 5 is a schematic diagram of a partial structure of the substrate in FIG. 3. FIG. 6 is a partial enlarged view of I in FIG. 5. FIG. 7 is a schematic diagram of a structure of a signal pair unit and a cable in FIG. 4.

Referring to FIG. 5 and FIG. 6, a plurality of pins may be provided in each lead region 100a, and the plurality of pins in each lead region 100a are electrically connected to a corresponding signal terminal 2111 of the cable connector assembly 200, so that each region is electrically connected to the cable 220 of the cable connector assembly 200 by the signal terminal 2111, and a plurality of cables 220 are led out from the plurality of pins in each region through the cable connector assembly 200. A component in the electronic device may be electrically connected to a corresponding pin on the circuit board 100 by connecting to the cable 220 in the cable connector assembly 200.

Referring to FIG. 1 and FIG. 2, the circuit board 100 in this embodiment of this application may include any one of a substrate 110 and a chip 120. The signal terminal 2111 of the cable connector assembly 200 may be electrically connected to a pin on the substrate 110, or may be electrically connected to a pin on the chip 120. In other words, the cable 220 may be led out from the substrate 110 through the cable connector assembly 200, and the cable 220 may also be led out from the chip 120 through the cable connector assembly 200.

For example, referring to FIG. 2 and FIG. 5, a plurality of lead regions 100a are provided on the substrate 110, and a plurality of pins are provided in each lead region 100a. The signal terminal 2111 of the cable connector assembly 200 may be electrically connected to a corresponding pin, so that the cable 220 on the cable connector assembly 200 is electrically connected to the corresponding pin, and it is ensured that the corresponding cable 220 is led out from each pin on the substrate 110.

Referring to FIG. 6, during actual application, a pad 111 is usually soldered on each pin, and the signal terminal 2111 of the cable connector assembly 200 is pressed against a corresponding pad 111, to increase a contact area between the signal terminal 2111 and the pin, so that reliability of an electrical connection between the signal terminal 2111 and the pin is ensured.

In this embodiment of this application, a specific structure of the cable connector assembly 200 is described in detail by using an example in which the cable connector assembly 200 is connected to the substrate 110.

Referring to FIG. 3 to FIG. 7, an example in which the cable connector assembly 200 is electrically connected to the lead region 100a on the substrate 110 is used for description.

A length direction of each lead region 100a on the substrate 110 is an x direction, a width direction is a y direction, and a height direction is a z direction.

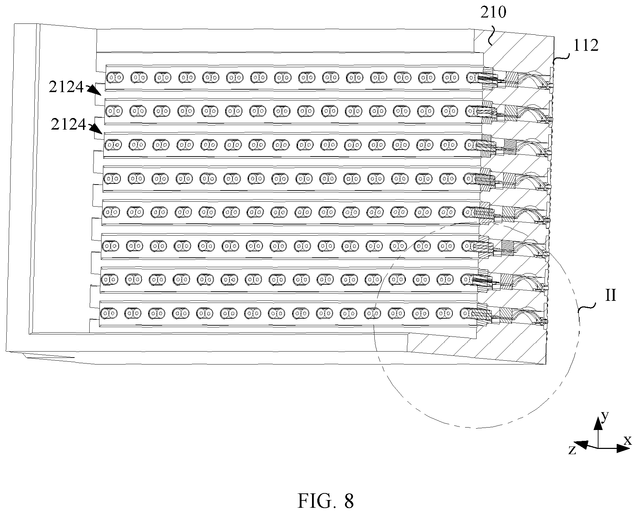

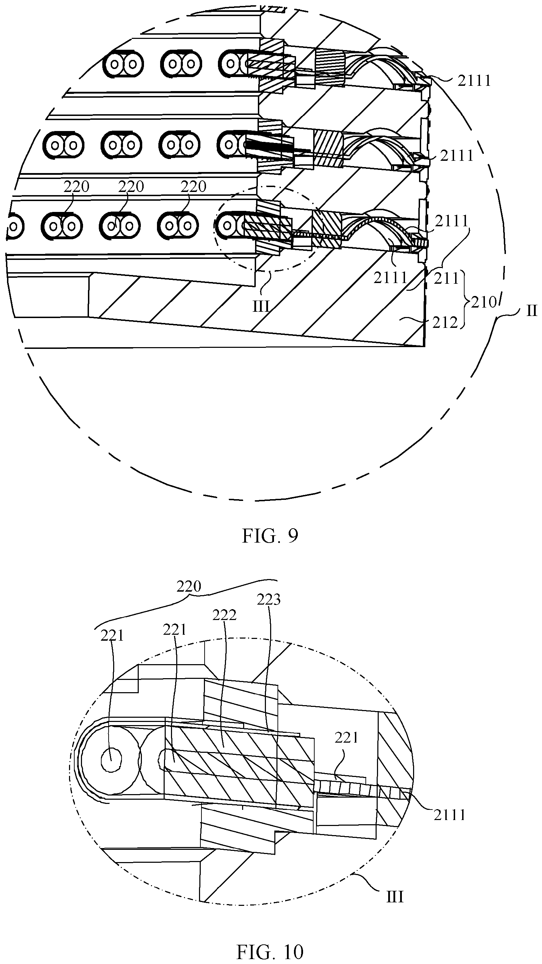

FIG. 8 is a schematic diagram of a partial structure in FIG. 4, FIG. 9 is a partial enlarged view of II in FIG. 8. FIG. 10 is a partial enlarged view of III in FIG. 9.

Referring to FIG. 5, during actual application, thousands of pins that are disposed at intervals are provided in each lead region 100a, and correspondingly, each pin has a corresponding pad 111. Referring to FIG. 8 and FIG. 9, the cable connector assembly 200 has a plurality of signal terminals 2111, and each signal terminal 2111 is in electrical contact with pads 111 on the thousands of pins, so that a plurality of cables 220 of the cable connector assembly 200 are electrically connected to corresponding pins on the circuit board 100. In this way, a component may be electrically connected to the plurality of cables 220 of the cable connector assembly 200, to implement electrical connection to the corresponding pins on the circuit board 100.

Referring to FIG. 4, specifically, the cable connector assembly 200 provided in this embodiment of this application includes a cable connector 210 and a plurality of cables 220. Referring to FIG. 7 and FIG. 8, the cable connector 210 includes a plurality of signal terminals 2111 that are disposed at intervals. It may be understood that the plurality of signal terminals 2111 are disposed corresponding to the plurality of cables 220, and one end of each signal terminal 2111 is electrically connected to a corresponding pin on the circuit board 100. For example, one end of each signal terminal 2111 is in electrical contact with the pad 111 on a corresponding pin on the circuit board 100, and the other end of each signal terminal 2111 is electrically connected to the corresponding cable 220. In this way, the plurality of cables 220 of the cable connector assembly 200 are electrically connected to the corresponding pins on the circuit board 100 by the corresponding signal terminals 2111, that is, the plurality of cables 220 are led out from the plurality of pins of the circuit board 100 through the plurality of signal terminals 2111 of the cable connector 210. In this way, the plurality of cables 220 in the cable connector assembly 200 are electrically connected to the component, to reduce a link loss of a high-speed link between the circuit board 100 and the component, and implement high-speed signal transmission.

It should be noted that one end and the other end of the signal terminal 2111 are two ends of the signal terminal 2111 that are disposed opposite to each other in an extension direction (referring to the z direction in FIG. 7). For ease of description, in this embodiment of this application, one end that is of the signal terminal 2111 and that is connected to the circuit board 100 is used as a first end (also referred to as a contact portion) of the signal terminal 2111, and one end that is of the signal terminal 2111 and that is electrically connected to the cable 220 is used as a second end (also referred to as a tail portion) of the signal terminal 2111.

It may be understood that the extension direction of the signal terminal 2111 refers to a direction from the first end to the second end of the signal terminal 2111. In other words, after the cable connector assembly 200 is electrically connected to the circuit board 100, for example, the substrate 110, the extension direction of the signal terminal 2111 refers to a direction of the signal terminal 2111 from the cable 220 to the substrate 110, as shown by the direction in FIG. 3. The extension direction of the signal terminal 2111 is perpendicular to a surface of the substrate 110 used to cooperate with the cable connector 210.

A surface that is on the substrate 110 and that is configured to be cooperatively connected to the cable connector 210 or the cable connector assembly 200 may be referred to as a mating surface 112 (referring to FIG. 5). Correspondingly, a surface that is of the cable connector 210 or the cable connector assembly 200 and that is configured to cooperate with the substrate 110 may be referred to as a mating surface 112 (referring to FIG. 8).

Referring to FIG. 5, an example in which a shape of each lead region 100a on the substrate 110 is a rectangle is used. A size of each lead region 100a is usually 4 mm×100 mm×18 mm, and there are thousands of pins in a space of 4 mm×100 mm×18 mm. In other words, there are thousands of pads 111 in the space of 4 mm×100 mm×18 mm, and the thousands of pads 111 in the space are connected to one cable connector assembly 200, to lead out a plurality of cables 220.

Referring to FIG. 5 and FIG. 6, the plurality of pads 111 in each lead region 100a on the substrate 110 may be arranged in an array. For example, the plurality of pads 111 may be arranged in an m×n array. It may be understood that m is a quantity of rows of an array formed by the pads 111, and n is a quantity of columns of the array formed by the pads 111. In this way, m is a quantity of the pads 111 that are disposed at intervals in a width direction (as shown in the y direction in FIG. 5) of each lead region 100a, and n is a quantity of the pads 111 that are disposed at intervals in a length direction (as shown in the x direction in FIG. 5) of each lead region 100a.

Referring to FIG. 5 and FIG. 6, for example, m is 8, and n is 32. That is, the quantity of the pads 111 in each lead region 100a is 256. In this case, in the cable connector 210 of the cable connector assembly 200 that is electrically connected to the region, a quantity of signal terminals 2111 is 256. In this way, each pin is electrically connected to the cable 220 by a corresponding signal terminal 2111.

Referring to FIG. 7 and FIG. 8, it may be understood that, in each cable connector 210, a layout manner of a plurality of signal terminals 2111 is consistent with that of the pads 111, that is, the plurality of signal terminals 2111 are also arranged in an m×n array. m is a quantity of rows of an array formed by the signal terminals 2111, and n is a quantity of columns of an array formed by the signal terminals 2111. In this way, m is a quantity of signal terminals 2111 that are disposed at intervals in a width direction (as shown in the y direction in FIG. 8) of each cable connector 210, n is a quantity of signal terminals 2111 that are disposed at intervals in a length direction (as shown in the x direction in FIG. 7 and FIG. 8) of each cable connector 210.

Certainly, m in this embodiment of this application may be any value greater than or less than 8. For example, m may be 5, 3, 12, or 15. Correspondingly, n may also be any value greater than or less than 8. For example, n may be 25, 15, 40, 50, or the like.

Referring to FIG. 7, to improve signal transmission performance of a high-speed link, the cable connector 210 provided in this embodiment of this application includes a plurality of signal pair units 211 that are disposed at intervals, and each signal pair unit 211 includes two signal terminals 2111. In other words, the two signal terminals 2111 are used as one signal pair unit 211. The two signal terminals 2111 in the signal pair unit 211 respectively transmit differential signals with the same amplitude and opposite phases, to ensure that a high-speed link can identify a small signal, and also improve an anti-interference capability of the high-speed link.

In the cable connector assembly 200, each signal terminal 2111 of the cable connector 210 is electrically connected to the corresponding cable 220, so that the cable 220 is electrically connected to a corresponding pad 111 on the substrate 110 by the corresponding signal terminal 2111, to lead out the cable 220 from each pin on the substrate 110.

Referring to FIG. 10, during actual application, each cable 220 includes a cable core 221, an insulating layer 222, and a conductive layer 223 that are sequentially sleeved from inside out. The cable core 221 is configured to transmit a high-speed signal, the conductive layer 223 is configured to ground the cable 220, and the insulating layer 222 insulates the cable core 221 from the conductive layer 223, to avoid a short circuit between the cable core 221 and the ground. The signal terminal 2111 in the cable connector 210 is specifically electrically connected to the cable core 221 in the cable 220.

In some examples, one cable core 221 may be provided in each cable 220. In this way, each signal terminal 2111 is electrically connected to one cable 220. In other words, one signal terminal 2111 is connected to one cable 220. In the cable connector assembly 200, a quantity of signal terminals 2111 is consistent with a quantity of cables 220, so that one cable 220 is led out from one pin on the circuit board 100, for example, the substrate 110.

Referring to FIG. 7 and FIG. 10, in some other examples, each cable 220 may have two cable cores 221 that are disposed at an interval, and the two cable cores 221 respectively correspond to two signal terminals 2111 of each signal pair unit 211, to transmit high-speed signals with equal current amplitudes and opposite phases. That is, each signal pair unit 211 is connected to one cable 220. In other words, two signal terminals 2111 in each signal pair unit 211 are connected to a same cable 220.

The circuit board 100 in this embodiment of this application is a high-density circuit board. For example, in each lead region 100a of the substrate 110, a maximum spacing (as shown by d1 in FIG. 6) between adjacent pads 111 is 0.6 mm. Therefore, each signal terminal 2111 in the cable connector assembly 200 needs to be electrically connected to a corresponding pin on the high-density circuit board 100, for example, the substrate 110.

Generally, in the plurality of pads 111 arranged in an array on the circuit board 100, a spacing between two adjacent rows of pads 111 is large, and a spacing between two adjacent pads 111 in each row of pads 111 is small. Therefore, generally, a maximum spacing between two adjacent rows of pads 111 is 0.6 mm, and a spacing between two adjacent pads 111 in each row of pads 111 is generally less than 0.6 mm.

It should be noted that the spacing between two adjacent pads 111 is a distance between centers of the two adjacent pads 111. During actual application, the spacing between two adjacent pads 111 may be referred to as a pitch.

Referring to FIG. 7, for ease of description, a region formed by two pads 111 used to electrically connect each signal pair unit 211 is used as a unit pad region 110a. Generally, a spacing d2 between unit pad regions 110a of two adjacent signal pair units 211 is less than or equal to 1.5 mm×1.8 mm. 1.5 mm is a spacing between two adjacent unit pad regions 110a in a same row, and 1.8 mm is a spacing between two adjacent unit pad regions 110a in two rows.

It should be noted that the spacing d2 between the two adjacent unit pad regions 110a is a distance between centers of the two adjacent unit pad regions 110a.

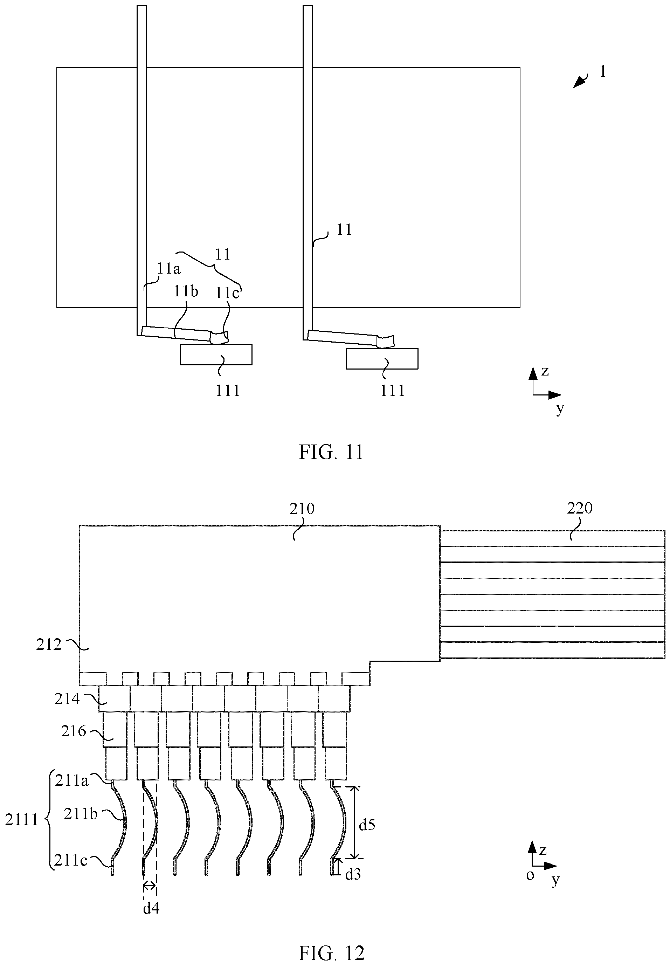

FIG. 11 is a schematic diagram of a partial structure of a cable connector in the related art. Referring to FIG. 11, in the related art, a signal terminal 11 of a cable connector 1 is provided with a main body portion 11a and a bent portion 11b in an extension direction (referring to a z direction in FIG. 11). One end of the main body portion 11a is electrically connected to the cable 220, the other end of the main body portion 11a is electrically connected to one end of the bent portion 11b, and the other end of the bent portion 11b is used as a first end of the signal terminal 2111 and is electrically connected to a pin on the circuit board 100. For example, the first end of the bent portion 11b is in electrical contact with the pad 111 on the circuit board 100.

Referring to FIG. 11, an extension direction of the main body portion 11a is consistent with the z direction, and the bent portion 11b extends in a direction that deviates from the z direction. For example, the bent portion 1 1b deviates from the extension direction of the main body portion 11a by an appropriate angle such as 30°, 45°, 60°, or 80°, so that the signal terminal 2111 has a particular elastic effect in the extension direction, that is, the z direction.

Still referring to FIG. 11, two signal terminals 11 in the cable connector 1 are used as an example. The two signal terminals 11 are sequentially disposed in the y direction, the two signal terminals 11 respectively correspond to two pads 111 that are sequentially disposed in the y direction on the circuit board 100, and the bent portion 11b of each signal terminal 11 is bent in the y direction. For example, the bent portion 11b deviates from an extension direction 80° of the corresponding signal terminal 11. In addition, a first end of each signal terminal 11, that is, one end of the bent portion 11b, is in electrical contact with a corresponding pad 111.

In the related art, the bent portion 1 1b of the signal terminal 11 may be used as an elastic arm of the signal terminal 11. When the cable connector 1 is assembled on the circuit board 100, the mating surface 112 of the circuit board 100 and another component of the cable connector 1 squeeze the elastic arm, and the elastic arm generates an elastic force, so that the first end of the signal terminal 11 is stably pressed against the pad 111 of the circuit board 100 under a pre-tightening effect of the elastic force. Therefore, more reliable electrical contact between the signal terminal 2111 and the pad 111 is ensured, and it is ensured that the signal terminal 2111 is electrically connected to a corresponding pin stably.

Referring to FIG. 11, during actual application, the signal terminal 11 is highly prone to movement on the pad 111. To keep the first end of the signal terminal 11 from scratching the pad 111, a hook 11c of an arc structure is generally disposed at the first end of the signal terminal 11, that is, an end of the bent portion 11b away from the main body portion 11a, and the hook 11c is bent in a direction away from the pad 111. In this way, an outer surface of the hook 11c having an arc-shaped structure is in contact with the pad 111, to reduce damage caused by the first end of the signal terminal 11 to the pad 111.

When the bent portion 11b of the signal terminal 11 is bent in the y direction, the bent portion 11b has a component in the y direction. In this way, when an extension length of the bent portion 11b is larger, the component in the y direction is larger, that is, an extension length of the mating surface 112 parallel to the circuit board 100 is larger. In other words, when the extension length of the bent portion 11b is larger, a space size occupied by the bent portion 11b in an arrangement direction of the pads 111 is larger. When a length of the bent portion 11b in the extension direction is longer, a pre-tightening force, that is, an elastic force, of the bent portion 11b is larger, so that when the cable connector 1 is assembled on the circuit board 100, one end of the signal terminal 11 can be stably pressed against a corresponding pad 111 on the circuit board 100.

However, because pin density of the circuit board 100 is high, that is, a spacing between two adjacent pins is small, and correspondingly, a spacing between the pads 111 corresponding to the two adjacent pins is also small. An extension length of the bent portion 11b in the signal terminal 11 is greatly limited, and elasticity of the signal terminal 11 is limited. As a result, when the cable connector 1 is electrically connected to the circuit board 100, one end of the signal terminal 11 cannot be stably pressed against the pin, for example, the pad 111, of the circuit board 100.

According to the cable connector 210 provided in this embodiment of this application, in the signal pair unit 211, the bent portion 211b of the signal terminal 2111 is disposed at the specific distance from the first end of the signal terminal 2111. In other words, the bent portion 211b of the signal terminal 2111 is moved up by a distance in a direction toward the second end, so that a portion of the signal terminal 2111 close to the first end is consistent with a main extension direction of the signal terminal 2111, that is, there is no bent portion 211b in another direction. In this way, when the cable connector 210 is assembled on the circuit board 100, the first end of the signal terminal 2111 and the portion close to the first end may be disposed perpendicular to the circuit board 100, to avoid that the portion close to the first end of the signal terminal 2111 occupies space of the circuit board 100 in a pin arrangement direction. An extension length of the bent portion 211b in a direction perpendicular to the main extension direction of the signal terminal 2111 may be adjusted, to improve elasticity of the signal terminal 2111 in the extension direction, and ensure reliability of contact between the first end of the signal terminal 2111 and the pin on the circuit board 100. Surface space of the circuit board 100 for contacting a mating surface 112 of the signal terminal 2111 is not occupied, so that the cable connector 210 forms a high-density cable connector 210, and is applicable to a circuit board 100 with high-density pins.

The following describes in detail a specific structure of the cable connector 210 in this embodiment of this application with reference to the accompanying drawings.

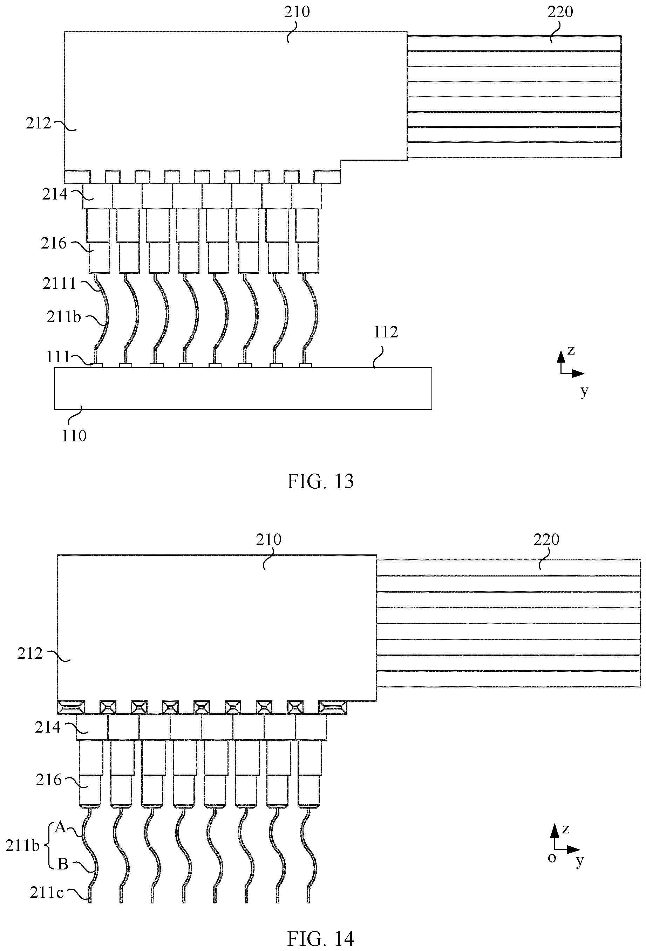

FIG. 12 is a right view of FIG. 8. FIG. 13 is an assembly diagram of a part of the cable connector assembly and the substrate in FIG. 4. Referring to FIG. 12 and FIG. 13, an embodiment of this application provides a cable connector 210, including a plurality of signal pair units 211 that are disposed at intervals. Each signal pair unit 211 includes two signal terminals 2111 that are disposed in parallel. Two signal terminals 2111 in each signal pair unit 211 respectively transmit height differential signals with a same amplitude and opposite phases, to improve signal transmission performance of a high-speed link in an electronic device.

Each signal terminal 2111 includes a first end and a second end that are disposed opposite to each other in an extension direction. The first end of each signal terminal 2111 is configured to electrically connect to a corresponding pin on the circuit board 100. For example, the first end of each signal terminal 2111 is in electrical contact with the pad 111 on the pin (referring to FIG. 13), and the second end of each signal terminal 2111 is configured to electrically connect to the corresponding cable 220 (referring to FIG. 9), so that the plurality of cables 220 are electrically connected to corresponding pins on the circuit board 100 by corresponding signal terminals 2111 in the cable connector 210.

Referring to FIG. 12, each signal terminal 2111 forms the bent portion 211b in the extension direction of the signal terminal 2111. The bent portion 211b refers to a portion of the signal terminal 2111 extending toward a side that deviates from the extension direction, so that the signal terminal 2111 is elastic in the extension direction. In this way, when the cable connector 210 is assembled on the circuit board 100, the signal terminal 2111 is compressed in the extension direction by using a mutual force between the cable connector 210 and the circuit board 100, and generates an elastic force. Under the action of the elastic force, the first end of the signal terminal 2111 may be stably pressed against the pad 111 of the circuit board 100, to be electrically connected to the pin stably.

There is a particular distance (referring to d3 in FIG. 12) between the bent portion 211b and the first end of the signal terminal 2111. In other words, an extension direction of at least a part of the signal terminal 2111 close to the first end is consistent with the extension direction of the signal terminal 2111. It should be noted that the distance between the bent portion 211b and the first end of the signal terminal 2111 is a distance between the first end and an end of the bent portion 211b opposite to the second end.

For example, each signal terminal 2111 includes a first main body portion 211a, a bent portion 211b, and a second main body portion 211c that are sequentially connected in the extension direction. One end of the first main body portion 211a is used as the second end of the signal terminal 2111, and is electrically connected to the corresponding cable 220, the other end of the first main body portion 211a is connected to one end of the bent portion 211b, one end of the second main body portion 211c is electrically connected to the other end of the bent portion 211b, and the other end of the second main body portion 211c is used as the first end of the signal terminal 2111, and is electrically connected to a corresponding pin on the circuit board 100. For example, the other end of the second main body portion 211c is in electrical contact with a corresponding pad 111 on the circuit board 100, for example, the substrate 110 (referring to FIG. 13).

Referring to FIG. 12, because the bent portion 211b in this embodiment of this application is located between two ends of the signal terminal 2111, an extension direction of the bent portion 211b may be considered as a direction in which the bent portion 211b deviates from the extension direction of the signal terminal 2111. For example, the extension direction of the bent portion 211b may be perpendicular to the extension direction of the signal terminal 2111, that is, the bent portion 211b bends in a direction perpendicular to the extension direction of the signal terminal 2111. It may be understood that the extension length of the bent portion 211b is a maximum distance (as shown in d4 in FIG. 12) by which the bent portion 211b deviates from the extension direction of the signal terminal 2111.

It may be understood that the bent portion 211b may be a plurality of planar structures that are sequentially connected. For example, the bent portion 211b may be one or more triangular structures, quadrilateral structures, or the like. The plurality of triangular structures are sequentially disposed in the z direction. In some examples, the bent portion 211b may also have an arc-shaped structure (referring to FIG. 12). For example, the bent portion 211b may be an arc-shaped portion that is bent in the direction perpendicular to the extension direction of the signal terminal 2111.

Extension directions of the first main body portion 211a and the second main body portion 211c are consistent with the extension direction of the signal terminal 2111. An extension length of the second main body portion 211c is d3. In other words, compared with the signal terminal 2111 in the related art, in this embodiment of this application, the bent portion 211b of the signal terminal 2111 is moved up by a distance of d3 in a direction toward the second end. d3 is a value greater than 0. For example, d3 may be an appropriate value such as 0.5 mm, 1 mm, 1.5 mm, or 2 mm.

In this embodiment of this application, the bent portion 211b of the signal terminal 2111 is moved up by a distance in a direction toward the second end, so that an extension direction of at least a part of the signal terminal 2111 close to the first end is consistent with the extension direction of the signal terminal 2111, that is, the portion is not bent in another direction. In this way, when the cable connector 210 is assembled on the circuit board 100, for example, the substrate 110, the portion of the signal terminal 2111 close to the first end, for example, the second main body portion 211c may be disposed perpendicular to the substrate 110 (as shown in FIG. 13), so that the second main body portion 211c has no component on the mating surface 112 parallel to the substrate 110, to avoid that the portion of the signal terminal 2111 close to the first end occupies space of the substrate 110 in the pin arrangement direction, that is, avoid that the portion of the signal terminal 2111 close to the first end occupies a surface size of the mating surface 112 of the substrate 110.

It should be noted that, that the second main body portion 211c of the signal terminal 2111 is perpendicular to the circuit board 100 may be that an included angle between the second main body portion 211c and the circuit board 100 is 90°, or 90°±10°. In other words, the second main body portion 211c of the signal terminal 2111 may be completely perpendicular to the circuit board 100, or may be tilted about 10° to the left or right.

Based on this, an extension length of the bent portion 211b in the direction perpendicular to the extension direction of the signal terminal 2111 may be increased, that is, a maximum distance d4 of the bent portion 211b that deviates from the extension direction of the signal terminal 2111 may be increased, so that elasticity of the signal terminal 2111 in the extension direction is improved, contact reliability between the first end of the signal terminal 2111 and the pad 111 on the circuit board 100 is ensured, and surface space of the circuit board 100 for contacting the mating surface 112 of the signal terminal 2111 is not occupied. A spacing between two adjacent signal terminals 2111 in the cable connector 210 may be reduced, to form a high-density and high-speed cable connector 210, so that the cable connector 210 may be applicable to the circuit board 100 with high-density pins, and reliability of an electrical connection between the signal terminal 2111 of the cable connector 210 and a pin on the circuit board 100 can be ensured.

In the high-density and high-speed cable connector 210, the high speed refers to an application scenario in which a rate exceeds 56 Gbit/s, and the high density refers to an application scenario in which a spacing between two adjacent unit pad regions 110a on the circuit board 100 is less than or equal to 1.5 mm×1.8 mm.

In addition, the signal terminal 2111 in the signal pair unit 211 is disposed to have the foregoing structure, so that when the first end of the signal terminal 2111 is pressed against and cooperates with the pad 111 on the circuit board 100, a compression process in a direction perpendicular to the circuit board 100 occurs, and the first end does not slide in a direction parallel to the circuit board 100, that is, does not slide on the mating surface 112 or a sliding distance is controlled within 0.1 mm. In this way, contact stability between the first end of the signal terminal 2111 and the pad 111 on the circuit board 100 can be ensured. In this way, when the signal terminal 2111 is electrically connected to the pin through the pad 111, a cross-sectional size of the pad 111 can be reduced, to ensure that impedance between the signal terminal 2111 and the pin is stable.

In addition, the signal terminal 2111 in this embodiment of this application does not need to occupy a size of the mating surface 112, so that appropriate space is provided for a shielding member of the cable connector 210, a reference ground of the circuit board 100, and a connection structure between the two, to ensure a shielding function of the first end of the signal terminal 2111, and improve anti-crosstalk performance of the signal terminal 2111.

In addition, in the related art, an arc hook is disposed at the first end of the signal terminal 2111, to avoid damage to the pad 111 on the pin when the signal terminal 2111 slides along the mating surface. Compared with the related art, in this embodiment of this application, the portion of the signal terminal 2111 close to the first end does not have a bent portion 211b, the first end of the signal terminal 2111 is perpendicularly pressed against the pin such as the pad 111 of the circuit board 100, and there is no sliding trend along the mating surface. Therefore, the first end of the signal terminal 2111 has no hook, a signal loss at the first end of the signal terminal 2111 is reduced, and performance of transmitting a high-speed signal by the signal pair unit 211 is ensured.

Referring to FIG. 12, a distance d5 between two ends of the bent portion 211b in the extension direction of the signal terminal 2111 also affects elasticity of the signal terminal 2111 to some extent. For example, in a specific range, when the distance d5 between the two ends of the bent portion 211b in the z direction is larger, elasticity of the signal terminal 2111 is larger, and the first end of the signal terminal 2111 is in closer contact with the pad 111 on the circuit board 100. Specifically, a value of d5 may be adjusted according to an actual requirement. This is not limited herein. For example, a distance ratio of d5 to the extension length of the signal terminal 2111 may be an appropriate ratio such as 1/2, 1/3, or 2/3.

Correspondingly, an extension length of the first main body portion 211a may be adjusted according to an actual length of the signal terminal 2111, which is not limited herein, provided that it is ensured that one end of the first main body portion 211a away from the bent portion 211b can be reliably connected to the corresponding cable 220.

Referring to FIG. 12, in this embodiment of this application, the bent portion 211b has one portion in the extension direction of the signal terminal 2111, and the portion may protrude in any direction perpendicular to the z direction. For example, the portion may protrude in the y direction. For example, the portion is an arc-shaped portion protruding in the y direction (referring to FIG. 12).

FIG. 14 is a schematic diagram of a structure of a signal pair unit and a cable in FIG. 4. Referring to FIG. 14, in some examples, the bent portion 211b is provided with a plurality of portions in the extension direction of the signal terminal 2111, and each portion protrudes in any direction perpendicular to the z direction. Bending directions of two adj acent portions are different. In other words, extension directions of the two adjacent portions are different. For example, in the two adjacent portions, one portion extends in a direction y in FIG. 14, and the other portion protrudes in a direction opposite to the direction y in FIG. 14. In this way, elasticity of the bent portion 211b in the extension direction of the signal terminal 2111 can be enhanced, so that the first end of the signal terminal 2111 can be stably pressed against the pad 111 of the circuit board 100, and it can be ensured that the bent portion 211b does not occupy a horizontal size of the mating surface 112 between the cable connector 210 and the circuit board 100.

Referring to FIG. 14, for example, the bent portion 211b has two portions in the extension direction of the signal terminal 2111. The two portions are a first portion A and a second portion B. One end of the first portion A is connected to the first main body portion 211a, the other end of the first portion A is connected to the second portion B, and the other end of the second portion B is connected to the second main body portion 211c. The first portion A extends in a reverse direction of the y direction in FIG. 14. In other words, the first portion A is bent in the reverse direction of the y direction in FIG. 14, and the second portion B extends in the y direction in FIG. 14. In other words, the second portion B is bent in the y direction in FIG. 14.

In the foregoing example, each portion of the bent portion 211b may have a polygonal structure or an arc structure. For example, the first portion A and the second portion B may have a triangular structure or an arc structure. When the first portion A and the second portion B have an arc structure, the bent portion 211b formed by the first portion A and the second portion B has a wave-shaped bent structure or a snake-shaped structure, that is, the bent portion 211b may form a wavy structure or a snake-shaped structure.

It may be understood that, in the foregoing example, each portion of the bent portion 211b extends in a same plane. For example, referring to FIG. 112 and FIG. 14, each portion of the bent portion 211b extends along a yoz plane, so that the bent portion 211b forms a snake-shaped structure or a wave-shaped structure.

In another example, each portion of the bent portion 211b may extend in different planes, that is, different regions of each portion in the extension direction are located in different planes. For example, the first portion A extends in the yoz plane, and the second portion B extends on an xoz plane, so that the bent portion 211b forms a spiral structure.

A structure of the bent portion 211b is not specifically limited in this embodiment of this application, provided that it is ensured that the bent portion 211b protrudes in the direction perpendicular to the extension direction of the signal terminal 2111.

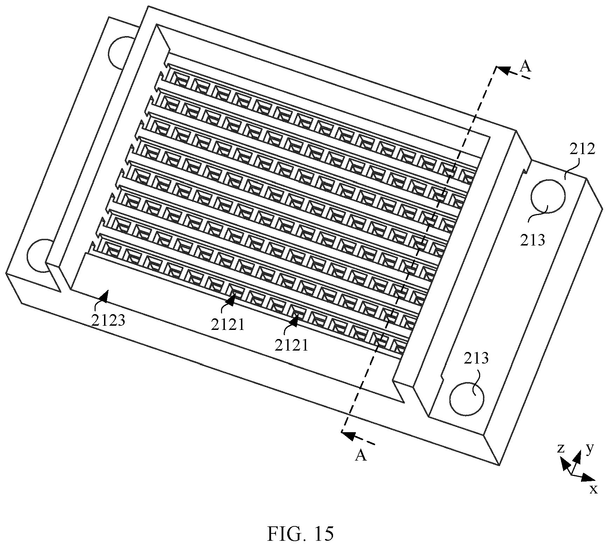

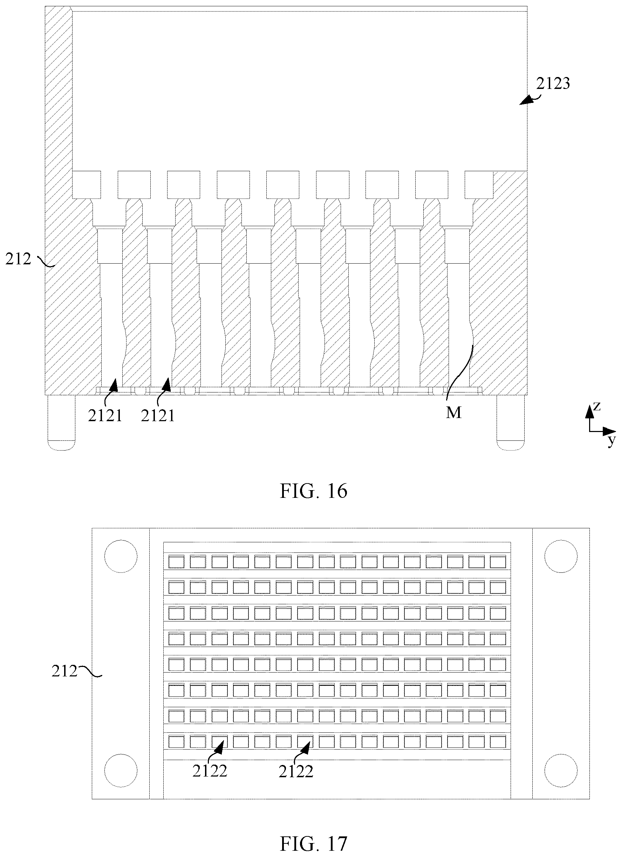

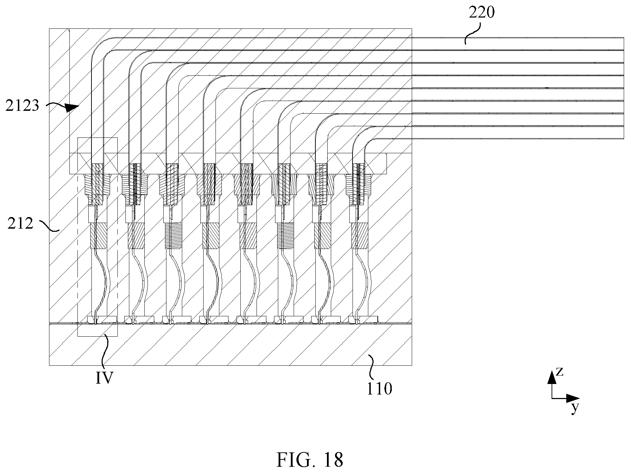

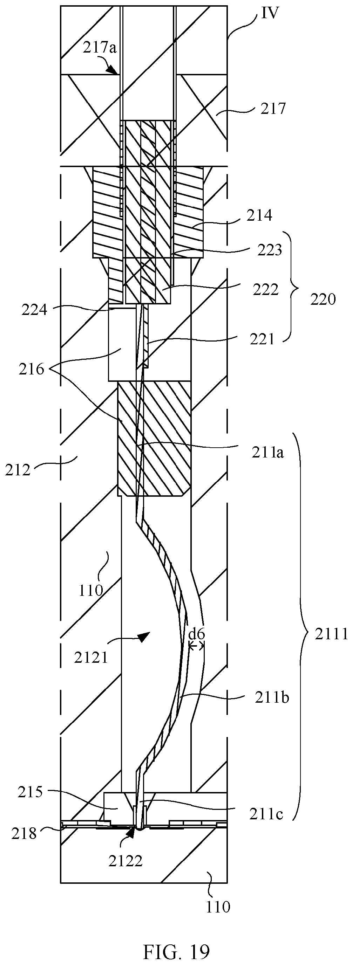

FIG. 15 is a schematic diagram of a structure of a conductive housing in FIG. 4. FIG. 16 is a cross-sectional view of FIG. 15 along A-A. FIG. 17 is a bottom view of FIG. 15. FIG. 18 is a cross-sectional view of FIG. 3 along B-B. FIG. 19 is a partial enlarged view of IV in FIG. 18. Referring to FIG. 15 to FIG. 19, in a feasible implementation, the cable connector 210 may further include a conductive housing 212. The conductive housing 212 is configured to electrically connect to a reference ground of the circuit board 100, for example, the substrate 110, so that the conductive housing 212 is grounded, to shield against an external signal.

The conductive housing 212 is made of a conductive material such as plastic electroplating or conductive plastic. For example, the conductive housing 212 may be integrally formed by using a process such as powder metallurgy, machining, or die casting.

Referring to FIG. 4 and FIG. 15, the conductive housing 212 may be connected to the circuit board 100 such as the substrate 110 by a screw, a bolt, or a rivet. For example, as shown in FIG. 4, a screw hole 213 is formed in the conductive housing 212, a screw hole 213 is also formed in the substrate 110, and the conductive housing 212 is connected to the substrate 110 by a fastener that passes through the screw holes 213.

Specifically, as shown in FIG. 16, the conductive housing 212 is provided with a plurality of shielding cavities 2121 that are provided at intervals. The plurality of shielding cavities 2121 are provided corresponding to the plurality of signal pair units 211. Each signal pair unit 211 is at least partially located in a corresponding shielding cavity 2121 (referring to FIG. 18). For example, in each signal pair unit 211, at least parts of two signal terminals 2111 in the extension direction are located in corresponding shielding cavities 2121. In this way, when the conductive housing 212 is electrically connected to the reference ground of the circuit board 100, the conductive housing 212 has a function of shielding against a signal, to effectively keep the signal pair units 211 from radiating high-speed signal waves to the outside and affecting signal transmission stability of each other. Therefore, anti-crosstalk performance of the signal pair units 211 in the cable connector 210 is improved.

Compared with the related art in which a stamping member is disposed between a tail and a head of the signal terminal 11, and the stamping member is used to implement an electrical connection between the cable connector 1 and the reference ground of the circuit board 100, in this embodiment of this application, a structure of an electrical connection between the cable connector 210 and the reference ground of the circuit board 100 is also simplified by arranging the conductive housing 212, to facilitate manufacturing of the cable connector 210.

Referring to FIG. 19, the signal pair unit 211 is insulated from an inner wall of the shielding cavity 2121, that is, any signal terminal 2111 in the signal pair unit 211 is insulated from the inner wall of the shielding cavity 2121, to avoid a short circuit between the signal terminal 2111 in the signal pair unit 211 and the conductive housing 212. For example, the signal terminal 2111 may be disposed at an interval from the inner wall of the shielding cavity 2121, to be insulated by using an air medium.

Referring to FIG. 18, a column of signal terminals 2111 in the cable connector 210 is used as an example. The cable connector 210 is provided with eight signal pair units 211 that are disposed at intervals in the y direction, the conductive housing 212 is provided with eight shielding cavities 2121 that are provided at intervals in the y direction, and signal terminals 2111 in each signal pair unit 211 are respectively disposed in the eight shielding cavities 2121, so that a signal of each signal pair unit 211 is shielded from the outside, so that it is ensured that crosstalk occurs between signals of the adjacent signal pair units 211.

It may be understood that an extension direction of each shielding cavity 2121 is consistent with the extension direction of the signal terminal 2111. For example, the extension direction of each shielding cavity 2121 may be the z direction.

Referring to FIG. 19, in some examples, a distance (referring to d6 in FIG. 15) between the bent portion 211b and the inner wall of the corresponding shielding cavity 2121 may be equal in the extension direction of the bent portion 211b. In other words, an internal structure of the bent portion 211b corresponding to the shielding cavity 2121 matches a structure perpendicular to the extension direction of the bent portion 211b, to ensure that characteristic impedance of the bent portion 211b is consistent in the extension direction, so that performance of the cable connector 210 for transmitting a high-speed signal is improved.

For example, if the bent portion 211b of the signal terminal 2111 is an arc-shaped structure protruding in the y direction, an inner wall of a position of the corresponding shielding cavity 2121 corresponding to the bent portion 211b is also an arc-shaped surface protruding in the y direction (as shown by M in FIG. 16), and a distance between the arc-shaped surface M and the bent portion 211b remains equal in the z direction.

Referring to FIG. 17, the conductive housing 212 is provided with a plurality of first avoidance openings 2122 at one end, and the plurality of first avoidance openings 2122 are provided corresponding to the plurality of shielding cavities 2121. Each first avoidance opening 2122 is connected to the corresponding shielding cavity 2121, and each first avoidance opening 2122 is configured to allow the first end of the corresponding signal terminal 2111 to penetrate out of the shielding cavity 2121, so that the first end of the signal terminal 2111 is in electrical contact with the pad 111 on the circuit board 100 (referring to FIG. 19).

For example, an inner bottom wall of each shielding cavity 2121 of the conductive housing 212 close to the first end of the signal terminal 2111 is provided with a first avoidance opening 2122. The first avoidance opening 2122 is configured to connect each shielding cavity 2121 to the outside of the conductive housing 212. In this way, the first end of the signal terminal 2111 of each signal pair unit 211 may extend from the corresponding first avoidance opening 2122, and is in electrical contact with a corresponding pin, for example, the pad 111, on the circuit board 100.

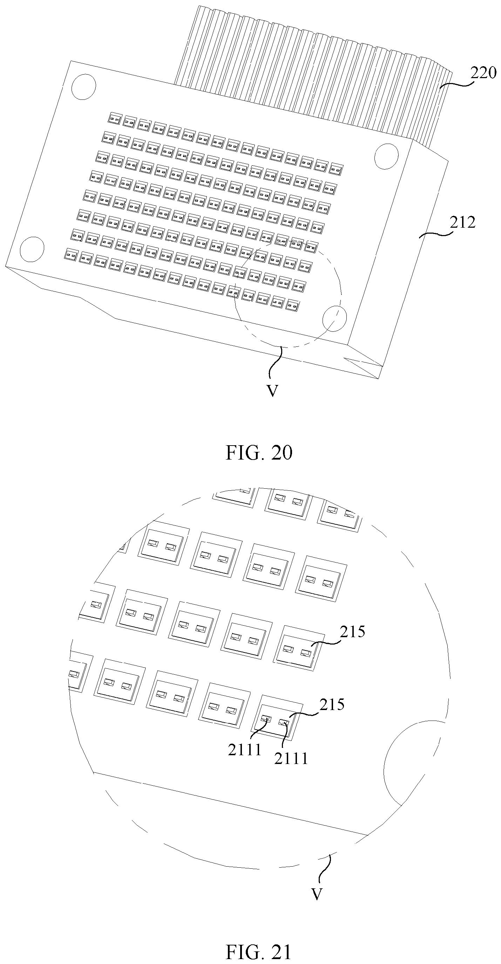

FIG. 20 is an assembly diagram of a conductive housing and a cable in FIG. 4. FIG. 21 is a partial enlarged view of V in FIG. 20. Referring to FIG. 19 to FIG. 21, the cable connector 210 may further include a plurality of first insulating members 215, and the plurality of first insulating members 215 are disposed corresponding to the plurality of signal pair units 211. Each first insulating member 215 is disposed between the corresponding signal terminal 2111 and an inner wall of the first avoidance opening 2122.

For example, referring to FIG. 19, the first insulating member 215 is disposed in each first avoidance opening 2122, and a through hole is provided in the first insulating member 215, for first ends of two signal terminals 2111 of each signal pair unit 211 to pass through (referring to FIG. 21).

During specific arrangement, the signal pair unit 211 may be first directly inserted into the corresponding shielding cavity 2121, and the first end of each signal terminal 2111 passes through the first avoidance opening 2122 at one end of the shielding cavity 2121, and then an insulating medium is filled between each first avoidance opening 2122 and the signal terminal 2111, to fasten each signal terminal 2111, and ensure that the first end of the signal terminal 2111 can be stably pressed against the pad of the circuit board 100. It may be understood that, the insulating medium is used as the first insulating member 215, and is filled between each first avoidance opening 2122 and the signal terminal 2111.

In addition, the first insulating member 215 is disposed to ensure effective insulation between the first end of the signal terminal 2111 and the conductive housing 212, keep the signal terminal 2111 from being short-circuited, and keep the signal terminal 2111 from shaking in a direction parallel to the mating surface to contact the conductive housing 212.

A composition material of the first insulating member 215 may include, but is not limited to, polybutylene terephthalate (polybutylene terephthalate, PBT for short), polycarbonate (polycarbonate, PC for short), paraformaldehyde (paraformaldehyde, POM for short), and polyurethane (polyurethane, PU for short), and may be specifically selected according to an actual requirement.

Referring to FIG. 7 to FIG. 19, the cable connector 210 in this embodiment of this application may further include a plurality of second insulating members 216, and the plurality of second insulating members 216 are disposed corresponding to the plurality of signal pair units 211. Each second insulating member 216 is disposed between the corresponding signal pair unit 211 and the inner wall of the shielding cavity 2121, and each second insulating member 216 is disposed close to the second end of the signal terminal 2111.

For example, the conductive housing 212 is provided with eight shielding cavities 2121 provided in the y direction, each shielding cavity 2121 is provided with one signal pair unit 211, and a second insulating member 216 is disposed between each signal pair unit 211 and the inner wall of the shielding cavity 2121. In other words, the second insulating member 216 effectively electrically isolates the signal pair unit 211 from the inner wall of the shielding cavity 2121, to ensure effective insulation between each signal terminal 2111 of the signal pair unit 211 and the conductive housing 212, and avoid a short circuit between the signal terminal 2111 and the conductive housing 212.

In addition, the second insulating member 216 is disposed to improve stability of the signal pair unit 211 in the shielding cavity 2121, and keep the signal pair unit 211 from shaking in an extension direction perpendicular to the signal terminal 2111, to improve electrical contact stability between the signal terminal 2111 of the signal pair unit 211 and the pad 111 on the circuit board 100, and keep the signal terminal 2111 from contacting the conductive housing 212 in a shaking process.

Referring to FIG. 7, it may be understood that, the second insulating member 216 is disposed on a side wall of each signal pair unit 211. In other words, two signal terminals 2111 of each signal pair unit 211 are wrapped inside the second insulating member 216 at the same time. In this way, the two signal terminals 2111 of each signal pair unit 211 may be fastened at the same time.

Referring to FIG. 10 and FIG. 19, during actual application, when two signal terminals 2111 of each signal pair unit 211 are electrically connected to one end of the cable 220, specifically, second ends of the two signal terminals 2111 are electrically connected to two cable cores 221 of the cable 220 respectively. For example, the second ends of the signal terminals 2111 may be soldered to the cable cores 221 of the cable 220.

At least a portion of the cable 220 configured to connect to one end of the signal terminal 2111 is provided with only a cable core 221 (as shown in FIG. 10 and FIG. 19), that is, the cable 220 is provided with no insulating layer 222 or conductive layer 223 at one end configured to connect to the signal terminal 2111, so that the cable core 221 of the cable 220 is soldered to the signal terminal 2111.

Referring to FIG. 19, in some examples, a connection between the second end of the signal terminal 2111 and the cable 220 may be located in the shielding cavity 2121, and the second insulating member 216 is at least partially located between the connection and the inner wall of the shielding cavity 2121, to protect a connection between the cable 220 and the signal terminal 2111. For example, when the cable 220 is connected to the signal terminal 2111 in a soldering manner, the second insulating member 216 may protect a solder joint, to avoid a case such as a break at the solder joint.

For example, referring to FIG. 19, one signal pair unit 211 is used as an example. A portion of the second insulating member 216 may be disposed on a periphery of a part of the first main body portion 211a, and the other part of the second insulating member 216 is disposed at a connection between the signal terminal 2111 and the cable 220, to ensure insulation between the connection between the cable core 221 and the signal terminal 2111 and the inner wall of the shielding cavity 2121.

It may be understood that materials of the second insulating member 216 and the first insulating member 215 may be the same or may be different. In this embodiment of this application, composition materials of the first insulating member 215 and the second insulating member 216 are not specifically limited, provided that it is ensured that the first insulating member 215 and the second insulating member 216 perform insulation. The first insulating member 215 and the second insulating member 216 may be formed through injection molding by using an insulating material.

Still referring to FIG. 19, each cable 220 is at least partially located in the corresponding shielding cavity 2121. For example, a tail of each cable 220, that is, a portion close to the signal terminal 2111, is located in a corresponding shielding cavity 2121, and the tail includes a complete portion of the cable 220 and a portion of the cable core 221 soldered to the signal terminal 2111. The complete portion of the cable 220 means that the portion is provided with the cable core 221, the insulating layer 222, and the conductive layer 223.

Referring to FIG. 19, to ensure that the cable 220 is stably grounded, the cable connector 210 in this embodiment of this application may further include a conductive medium 214 (as shown in FIG. 7), and the conductive medium 214 is filled between the conductive layer 223 and the inner wall of the shielding cavity 2121.

In this embodiment of this application, the conductive medium 214 is filled between the conductive layer 223 of the cable 220 and the shielding cavity 2121. In one aspect, the conductive layer 223 of the cable 220 may be electrically connected to the conductive housing 212. In this way, when the conductive housing 212 is electrically connected to the reference ground of the circuit board 100, the conductive layer 223 of the cable 220, the conductive housing 212, and the reference ground of the circuit board 100 form a good ground return current system, to improve an external shielding function of the cable connector 210 and the cable 220, avoid mutual crosstalk between the cable connector 210 and the cable 220 and an external signal, and also avoid signal crosstalk between the signal pair units 211 inside the cable connector 210.

A composition material of the conductive medium 214 may be metal, an alloy, or a polymer conductive material such as conductive plastic, conductive solder, or a conductive adhesive. A specific composition of the conductive medium 214 is not specifically limited in this embodiment of this application.

Referring to FIG. 7, in addition, the cable 220 further includes a cable insulator 224. The cable insulator 224 is disposed on a periphery of one end of the cable core 221 connected to the signal terminal 2111. In this way, one end of the cable core 221 connected to the signal terminal 2111 may be separated from an inner side wall of the conductive housing 212 by the cable insulator 224 (referring to FIG. 19), to avoid a short circuit caused by electrical contact between a connection such as a solder joint between the cable core 221 and the signal terminal 2111 and an inner wall of the conductive housing 212.

During specific arrangement, referring to FIG. 7, the cable insulator 224 may be disposed between the cable core 221 and the second insulating member 216, so that the cable core 221 is separated from the inner side wall of the conductive housing 212 by the cable insulator 224 and the second insulating member 216, to further improve insulation performance between one end of the cable core 221 configured to connect to the signal terminal 2111 and the conductive housing 212.

Referring to FIG. 15 and FIG. 18, the conductive housing 212 in this embodiment of this application may further include an accommodating groove 2123. The accommodating groove 2123 is located on a side of all shielding cavities 2121 opposite to the first avoidance opening 2122, and a part of each cable 220 is further located in the accommodating groove 2123.

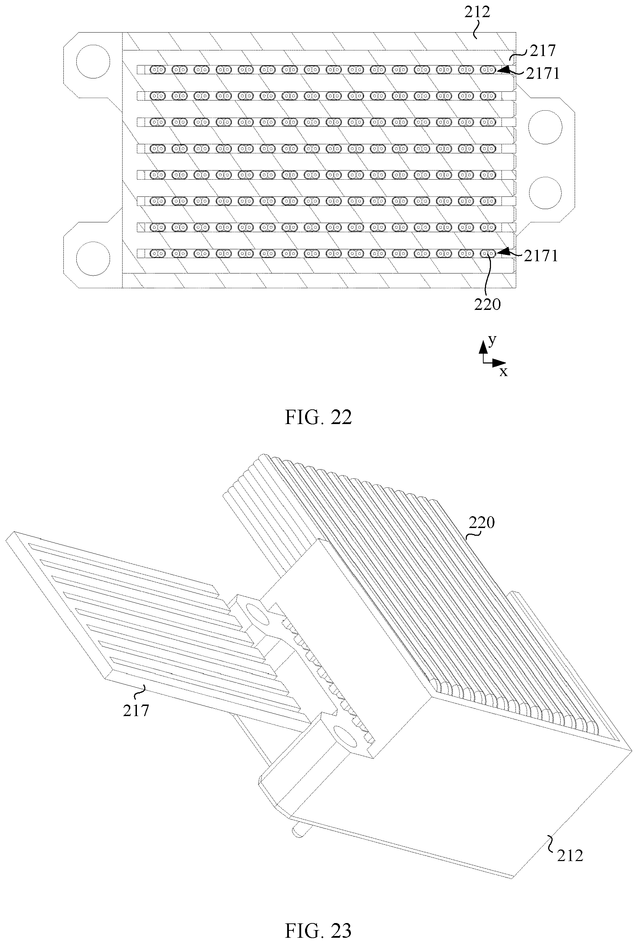

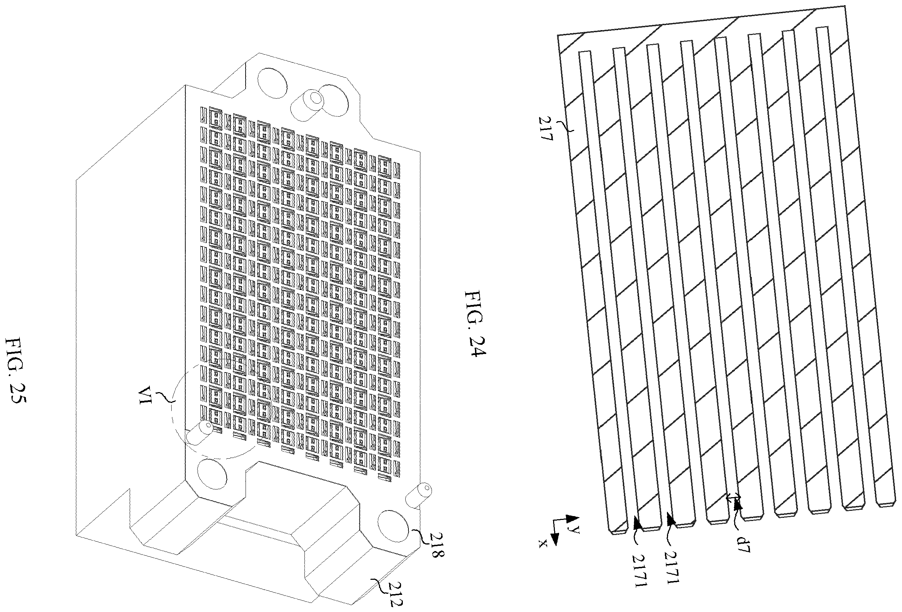

FIG. 22 is a top view of FIG. 19. FIG. 23 is a partial exploded view of FIG. 4. FIG. 24 is a schematic diagram of a structure of a thrust member shown in FIG. 23. Referring to FIG. 19, in some examples, the cable connector 210 further includes a thrust member 217. The thrust member 217 is disposed in the accommodating groove 2123 of the conductive housing 212, and an outer edge of the thrust member 217 is connected to an inner wall of the accommodating groove 2123, to fasten the thrust member 217 in the accommodating groove 2123 of the conductive housing 212. For example, a mounting groove 2124 (as shown in FIG. 8) is provided in an inner side wall of the accommodating groove 2123, and one end of the thrust member 217 extends into the mounting groove 2124, to limit movement of the thrust member 217 in the z direction and the y direction.

It may be understood that the thrust member 217 is attached to a surface (as shown in FIG. 19) of a side of the conductive medium 214 facing the first avoidance opening 2122.

Referring to FIG. 22 and FIG. 24, the thrust member 217 is provided with a plurality of third avoidance openings 2171, each third avoidance opening 2171 is configured to allow a corresponding cable 220 to pass through, and a width of each third avoidance opening 2171 is less than a cross-sectional size of each signal terminal 2111. In this way, the thrust member 217 can be used to stop the signal terminal 2111 in the conductive housing 212, to keep the signal terminal 2111 from loosening in the shielding cavity 2121, so that the signal terminal 2111 is kept from being detached from the shielding cavity 2121. Referring to FIG. 24, the thrust member 217 is provided with a plurality of rows of strip holes extending in the x direction, and the strip holes are used as the third avoidance openings 217a, for the cable 220 in each row of shielding cavities 2121 to pass through to the outside of the conductive housing 212.

It may be understood that the strip hole is provided to divide the thrust member 217 into a plurality of strip members, and ends of the plurality of strip members are respectively in the plurality of mounting grooves 2124 provided in the inner walls of the accommodating grooves 2123. The width of the third avoidance opening 217a, that is, the strip hole, is a width of the third avoidance opening 217a that is perpendicular to the extension direction, that is, the x direction.

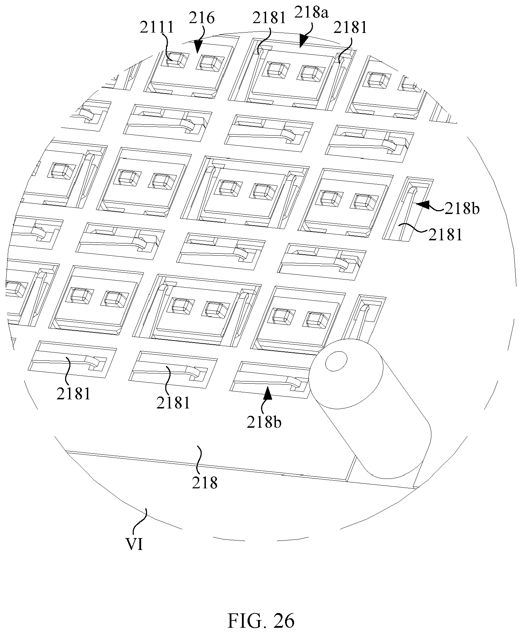

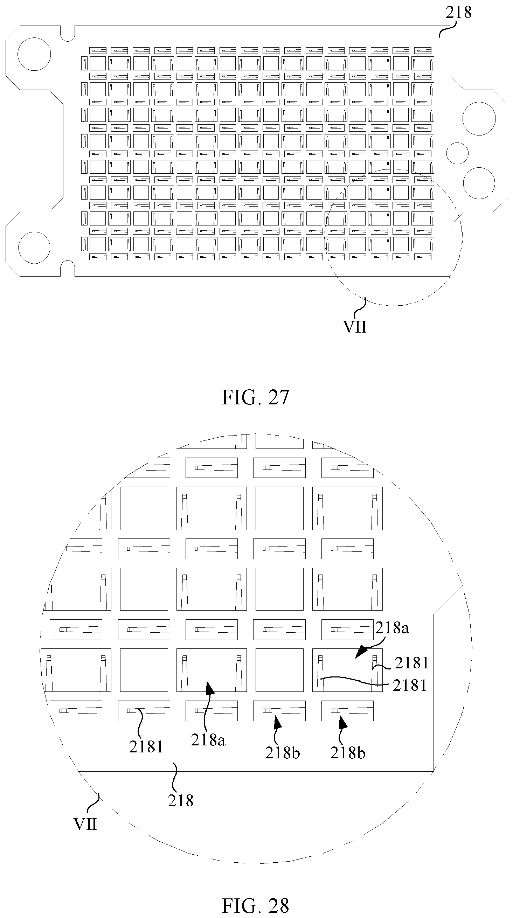

FIG. 25 is a schematic diagram of a structure of a cable connector in FIG. 4. FIG. 26 is a partial enlarged view of VI in FIG. 25. FIG. 27 is a schematic diagram of a structure of a ground contact member shown in FIG. 25. FIG. 28 is a partial enlarged view of VII in FIG. 27. Referring to FIG. 25 to FIG. 28, in some examples, the cable connector 210 may further include a ground contact member 218. The ground contact member 218 is disposed on a side of the conductive housing 212 close to the first end of the signal terminal 2111, one side of the ground contact member 218 is electrically connected to the conductive housing 212, and the other side of the ground contact member 218 is configured to electrically connect to the reference ground of the circuit board 100 (referring to FIG. 19).

It may be understood that, referring to FIG. 26 and FIG. 27, there are a plurality of second avoidance openings 218a in the ground contact member 218, and each second avoidance opening 218a is configured to allow a corresponding signal terminal 2111 to pass through, to ensure that the signal terminal 2111 that passes through the conductive housing 212 can be electrically connected to a pin on the circuit board 100.

In this embodiment of this application, a ground contact member 218 is disposed on a side of the conductive housing 212 close to the first end of the signal terminal 2111, so that the conductive housing 212 is electrically connected to the reference ground of the circuit board 100 by the ground contact member 218, to ensure a signal shielding effect of the conductive housing 212.

Still referring to FIG. 26, an elastic member 2181 is provided on the ground contact member 218, and an elastic direction of the elastic member 2181 is consistent with the extension direction of the signal terminal 2111. In this way, when the cable connector 210 is electrically connected to the circuit board 100, the ground contact member 218 may be squeezed by the conductive housing 212 and the circuit board 100, so that the ground contact member 218 can be in close electrical contact with the reference ground of the circuit board 100 under a pre-tightening force of the elastic member 2181, to ensure reliability of an electrical connection between the conductive housing 212 and the reference ground of the circuit board 100.

The elastic member 2181 may be a spring (not shown in the figure) disposed on a surface of the ground contact member 218, and an extension direction of the spring is consistent with a thickness direction of the ground contact member 218, that is, the extension direction of the spring is the z direction.

Referring to FIG. 26 and FIG. 28, in some examples, the elastic member 2181 is configured as an elastic arm. In other words, the elastic member 2181 may be an elastic arm, an extension direction of the elastic arm is perpendicular to the extension direction of the signal terminal 2111, one end of the elastic arm is connected to the ground contact member 218, and the other end of the elastic arm is configured to electrically connect to the reference ground of the circuit board 100.

The elastic member 2181 is disposed as the elastic arm. In one aspect, tightness of electrical contact between the ground contact member 218 and the reference ground of the circuit board 100 is ensured. In another aspect, the elastic arm is disposed to improve stability of a connection between the elastic member 2181 and the ground contact member 218, and also simplify a structure of the elastic member 2181.

In the plurality of elastic arms used as the elastic members 2181, some elastic arms or all the elastic arms may be disposed in the second avoidance opening 218a. For example, the second avoidance opening 218a is provided with a first inner side wall and a second inner side wall that are disposed opposite to each other. One end of the elastic arm is connected to the first inner side wall, the other end of the elastic arm extends to the second inner side wall, and the other end of the elastic arm is in contact with the reference ground of the circuit board 100, for example, the substrate 110.

The elastic arm is disposed in the second avoidance opening 218a, to appropriately use space in the second avoidance opening 218a. This avoids that the elastic arm occupies a space size of a side of the ground contact member 218 opposite to the conductive housing 212, that is, the mating surface, and avoids that the elastic arm causes interference to the signal terminal 2111, to avoid affecting electrical contact between the signal terminal 2111 and the pin on the circuit board 100.

Referring to FIG. 28, one or more elastic arms may be disposed in at least some second avoidance openings 218a. For example, each second avoidance opening 218a has a quadrilateral structure, and elastic arms are disposed on two opposite inner walls of the second avoidance opening 218a.

Referring to FIG. 28, in addition, to increase contact tightness between the ground contact member 218 and the circuit board 100, a plurality of mounting holes 218b may be additionally provided in the ground contact member 218, and an elastic arm is disposed in each mounting hole 218b. The extension direction of the elastic arm located in the mounting hole 218b may be perpendicular to the extension direction of the elastic arm at the second avoidance opening 218a.

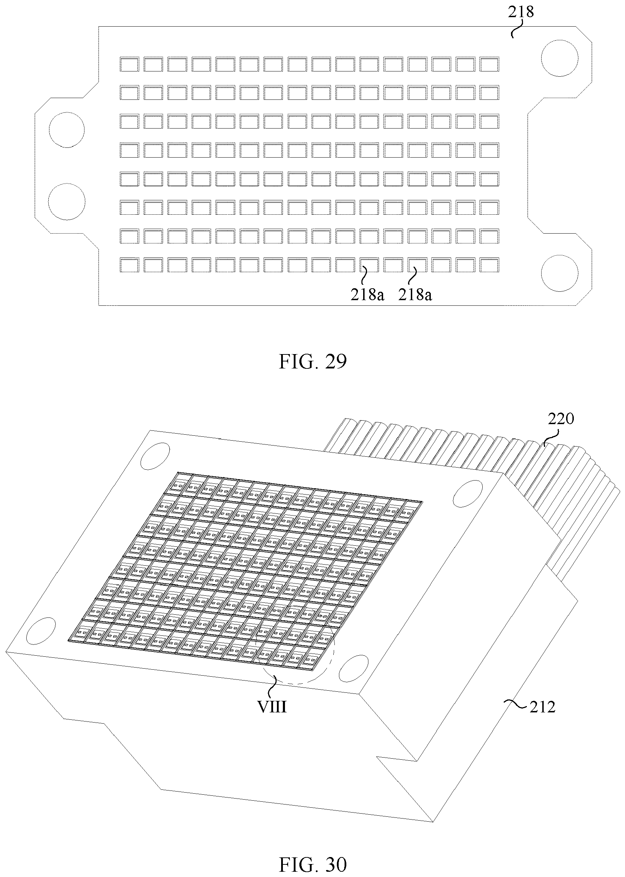

FIG. 29 is a schematic diagram of another structure of a ground contact member shown in FIG. 4. Referring to FIG. 29, in some other examples, the ground contact member 218 may be further configured as an elastic buffer member. For example, there is no elastic member 2181 on the ground contact member 218, and the ground contact member 218 is made of an elastic conductive material. In this way, when the cable connector 210 is electrically connected to the circuit board 100, the ground contact member 218 is compressed by using an elastic function of the ground contact member 218, so that the ground contact member 218 generates an elastic force perpendicular to the circuit board 100, to ensure that the ground contact member 218 is in close contact with the reference ground of the circuit board 100, and ensure reliability of grounding of the conductive housing 212.

The ground contact member 218 may be conductive rubber, foam, or the like.

During specific assembly, the ground contact member 218 may be tightly fastened between the conductive housing 212 and the circuit board 100 by a fastening screw or the like, so that an elastic material of the ground contact member 218 is compressed, and the conductive housing 212 is closely connected to the circuit board 100. In this way, it is ensured that the conductive housing 212 is reliably electrically connected to the reference ground on the circuit board 100, and in addition, it is ensured that the signal terminal 2111 is in close contact with the pad 111 on the circuit board 100.

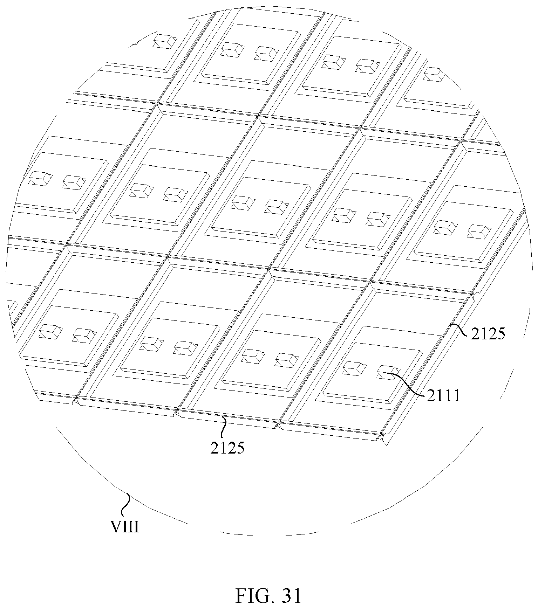

FIG. 30 is an assembly diagram of another conductive housing and a cable in FIG. 4. FIG. 31 is a partial enlarged view of VIII in FIG. 30. Referring to FIG. 30 and FIG. 31, to enhance a compression degree of the ground contact member 218, a convex rib 2125 may be provided on a side of the conductive housing 212 facing the ground contact member 218 in this embodiment of this application, and the convex rib 2125 is pressed against the ground contact member 218.

The convex rib 2125 is disposed on the side of the conductive housing 212 facing the ground contact member 218, so that when the cable connector 210 is assembled with the circuit board 100, the convex rib 2125 can squeeze the ground contact member 218, to increase a compression amount of an elastic material at a corresponding position of the ground contact member 218. In this way, contact between a position of the convex rib 2125 corresponding to the ground contact member 218 and the reference ground of the circuit board 100 is closer.

A plurality of convex ribs 2125 may be disposed on a surface of one side of the conductive housing 212 in the x direction and the y direction in sequence, to increase a fitting amount between the convex rib 2125 and the ground contact member 218, so that contact performance of the ground contact member 218 and the circuit board 100 is better, and therefore, the ground contact member 218 is increased. It may be understood that the convex rib 2125 extending in the x direction and the convex rib 2125 extending in the y direction are disposed in a cross manner, and in addition, all convex ribs 2125 are disposed away from the first avoidance opening 2122.

Referring to FIG. 4, the cable connector 210 in this embodiment of this application may further include a fixing adhesive 219. The fixing adhesive 219 is disposed in the accommodating groove 2123, and the fixing adhesive is filled in a gap between each cable 220 and the inner wall of the accommodating groove 2123. In this way, the thrust member 217, the conductive medium 214, and the signal terminal 2111 may be stably fastened in the conductive housing 212, to keep the signal terminal 2111 from loosening in or even being detached from the shielding cavity 2121 of the conductive housing 212.

In addition, the fixing adhesive may play a positioning role for a portion of the cable 220, so that an end of the cable 220 close to the signal terminal 2111 is more stable in the conductive housing 212, to improve connection stability between the cable 220 and the signal terminal 2111.

The fixing adhesive 219 may be a conductive adhesive.

In the cable connector assembly 200 further provided in this embodiment of this application, the cable connector 210 is disposed. An extension length of a bent portion 211b in the signal terminal 2111 in a direction perpendicular to a main extension direction of the main extension direction of the signal terminal 2111 is adjusted, to improve elasticity of the signal terminal 2111 in the main extension direction, and ensure reliability of contact between a first end of the signal terminal 2111 and a pin on the circuit board 100, so that reliability of an electrical connection between the cable connector assembly 200 and the pin on the circuit board 100 is ensured. In addition, the signal terminal 2111 in the cable connector assembly 200 does not occupy surface space of the circuit board 100 for contacting a mating surface of the signal terminal 2111. In this way, the cable connector 210 is applicable to a circuit board 100 with high-density pins.

In the circuit board assembly provided in this embodiment of this application, the cable connector assembly 200 is disposed in the circuit board assembly, so that a portion of the signal terminal 2111 close to the first end in the cable connector assembly 200 does not occupy space of the circuit board 100 in a pin arrangement direction. An extension length of a bent portion 211b in a direction perpendicular to a main extension direction of the main extension direction of the signal terminal 2111 may be adjusted, to improve elasticity of the signal terminal 2111 in the main extension direction, and ensure reliability of contact between the first end of the signal terminal 2111 and a pin on the circuit board 100, so that reliability of an electrical connection between the cable 220 and the pin on the circuit board 100 is ensured. The portion of the signal terminal 2111 close to the first end does not occupy surface space of a mating surface of the circuit board 100, so that the cable connector 210 is applicable to a circuit board 100 with high-density pins, to ensure signal transmission performance of a high-density circuit board assembly.

Referring to FIG. 7, a pad 111 is provided on a pin on the circuit board 100, and one end of the signal terminal 2111 is in electrical contact with the pad 111, to increase an electrical contact area between the signal terminal 2111 and the pin, so that electrical contact reliability between the signal terminal 2111 and the pin is improved. It may be understood that, in the cable connector 210 in this embodiment of this application, a portion of the signal terminal 2111 electrically connected to the circuit board 100 is perpendicular to the circuit board 100, and does not occupy surface space of a mating surface of the circuit board 100. Therefore, a size of the pad 111 on the circuit board 100 may be smaller than a size of a pad 111 in the related art.

The pad 111 of a rectangular structure is used as an example. Both a length and a width of the pad 111 on the circuit board 100 in this embodiment of this application may be less than 0.4 mm, so that high-density layout of pins on the circuit board 100 can be implemented.

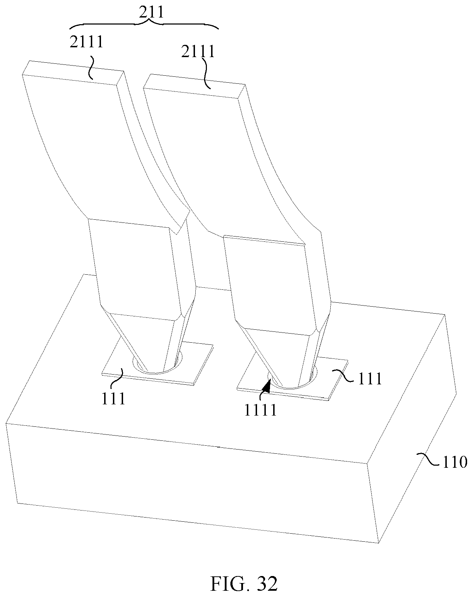

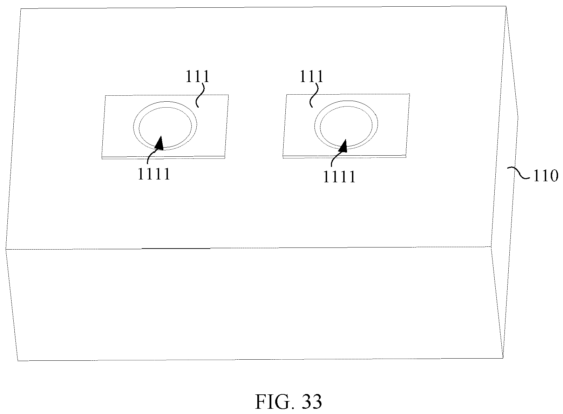

FIG. 32 is a schematic diagram of a structure of the substrate and a signal terminal in FIG. 18. FIG. 33 is a schematic diagram of a structure of the substrate in FIG. 32. Referring to FIG. 23 and FIG. 33, in some examples, a groove 1111 may be provided in the pad 111, and the first end of the signal terminal 2111 is located in the groove 1111.

The groove 1111 is provided in the pad 111, and the first end of the signal terminal 2111 is disposed in the groove 1111, to limit movement of the first end of the signal terminal 2111 on a surface of the pad 111, and ensure contact stability of the first end of the signal terminal 2111 on the pad 111, so that impedance stability of the first end of the signal terminal 2111 is ensured.

For example, when the groove 1111 is provided at the center of the pad 111, the first end of the signal terminal 2111 may be limited at the center of the pad 111, to ensure that high-speed transmission performance of the signal terminal 2111 is more stable.

In other words, the substrate 110 may be electrically connected to a cable 220 by the cable connector 210 in this embodiment of this application, to improve contact stability between the pin on the substrate 110 and the signal terminal 2111 in the cable connector 210, and the signal terminal 2111 does not occupy space on a surface of the substrate 110, so that the cable connector 210 is applicable to a high-density substrate 110. Correspondingly, the chip 120 may also be electrically connected to the cable 220 by the cable connector 210 in this embodiment of this application, to improve contact stability between a pin on the chip 120 and a signal terminal 2111 in the cable connector 210, and the signal terminal 2111 does not occupy surface space of the chip 120 for contacting a mating surface of the signal terminal 2111, so that the cable connector 210 is applicable to a high-density chip 120.

It should be noted herein that values and value ranges in embodiments of this application are approximate values, and an error within a specific range may exist due to impact of a manufacturing process. A person skilled in the art may consider that the error is negligible.

It should be understood that, in this application, "electrical connection" may be understood that components contact physically and conduct electrically. It may also be understood as a form in which different components in a line structure are connected through physical lines that can transmit an electrical signal, such as a printed circuit board (printed circuit board, PCB) copper foil or a conducting wire. "Coupling" may be understood as conducting through air in an indirect coupling manner. The coupling in this application may be understood as capacitive coupling. For example, an equivalent capacitor is formed by coupling between gaps between two conductive members, to implement signal transmission. A person skilled in the art may understand that the coupling phenomenon refers to a phenomenon that input and output of two or more circuit elements or electrical networks closely cooperate with each other and affect each other, and energy is transmitted from one side to the other side through interaction. A "communication connection" may refer to an electrical signal transmission, including a wireless communication connection and a wired communication connection. The wireless communication connection does not require a physical medium and does not belong to a connection relationship that defines a construction of a product. Both "connection" and "connected to" may refer to a mechanical connection relationship or a physical connection relationship. That is, a connection between A and B or that A is connected to B may mean that there is a fastening component (for example, a screw, a bolt, a rivet, or the like) between A and B; or A and B are in contact with each other and A and B are difficult to be separated.

In descriptions of embodiments of this application, it should be noted that, unless otherwise clearly specified and limited, the terms "installation", "connection to", and "connection" should be understood in a broad sense. For example, the connection may be a fixed connection, may be an indirect connection by using an intermediate medium, or may be an internal connection between two elements or an interaction relationship between two elements. For a person of ordinary skill in the art, specific meanings of the foregoing terms in embodiments of this application may be understood based on a specific situation.

In the specification, claims, and accompanying drawings in embodiments of this application, the terms "first", "second", "third", "fourth", and so on (if available) are intended to distinguish between similar objects but do not necessarily indicate a specific order or sequence.

## Claims

1. A cable connector, comprising a plurality of signal pair units that are disposed at intervals, wherein
each signal pair unit comprises two signal terminals that are disposed in parallel, a first end of each signal terminal is configured to be in electrical contact with a corresponding pin on a circuit board, and a second end of each signal terminal is configured to electrically connect to a corresponding cable; and
a bent portion is formed on each signal terminal in an extension direction of the signal terminal, and there is a specific distance between the bent portion and the first end.

2. The cable connector according to claim 1, wherein the bent portion is provided with a plurality of portions in the extension direction of the signal terminal; and
in the plurality of portions, two adjacent portions have different bending directions.

3. The cable connector according to claim 1 or 2, wherein the cable connector further comprises a conductive housing, and the conductive housing is configured to electrically connect to a reference ground of the circuit board; and
the conductive housing is provided with a plurality of shielding cavities that are provided at intervals, the plurality of shielding cavities are provided corresponding to the plurality of signal pair units, each signal pair unit is at least partially located in a corresponding shielding cavity, and the signal pair unit is insulated from an inner wall of the shielding cavity.

4. The cable connector according to claim 3, wherein a distance between the bent portion and the inner wall of the corresponding shielding cavity is equal in an extension direction of the bent portion.

5. The cable connector according to claim 3 or 4, wherein the conductive housing is provided with a plurality of first avoidance openings at one end, and the plurality of first avoidance openings are provided corresponding to the plurality of shielding cavities; and
each first avoidance opening is connected to the corresponding shielding cavity, and each first avoidance opening is configured to allow the first end of the corresponding signal terminal to penetrate out of the shielding cavity.

6. The cable connector according to claim 5, wherein the cable connector further comprises a plurality of first insulating members, and the plurality of first insulating members are disposed corresponding to the plurality of signal pair units; and
each first insulating member is disposed between the corresponding signal terminal and an inner wall of the first avoidance opening.

7. The cable connector according to any one of claims 3 to 6, wherein the cable connector further comprises a plurality of second insulating members, and the plurality of second insulating members are disposed corresponding to the plurality of signal pair units; and
each second insulating member is disposed between the corresponding signal pair unit and the inner wall of the shielding cavity, and each second insulating member is disposed close to the second end of the signal terminal.

8. The cable connector according to claim 7, wherein a connection between the second end of the signal terminal and the cable is located in the shielding cavity, and the second insulating member is at least partially located between the connection and the inner wall of the shielding cavity.

9. The cable connector according to any one of claims 3 to 8, wherein each cable is at least partially located in the corresponding shielding cavity;
each cable comprises a cable core, an insulating layer, and a conductive layer that are sequentially sleeved from inside out; and
the cable connector further comprises a conductive medium, wherein the conductive medium is filled between the conductive layer and the inner wall of the shielding cavity.

10. The cable connector according to any one of claims 3 to 9, wherein the cable connector further comprises a ground contact member;
the ground contact member is disposed on a side of the conductive housing close to the first end of the signal terminal, one side of the ground contact member is electrically connected to the conductive housing, and the other side of the ground contact member is configured to electrically connect to the reference ground of the circuit board; and
the ground contact member is provided with a plurality of second avoidance openings, and each second avoidance opening is configured to allow the corresponding signal terminal to pass through.

11. The cable connector according to claim 10, wherein an elastic member is provided on the ground contact member, and an elastic direction of the elastic member is consistent with the extension direction of the signal terminal.

12. The cable connector according to claim 11, wherein the elastic member is configured as an elastic arm, an extension direction of the elastic arm is perpendicular to the extension direction of the signal terminal, one end of the elastic arm is connected to the ground contact member, and the other end of the elastic arm is configured to electrically connect to the reference ground of the circuit board.

13. The cable connector according to claim 12, wherein the elastic arm is disposed in the second avoidance opening.

14. The cable connector according to claim 11, wherein the ground contact member is configured as an elastic buffer.

15. The cable connector according to claim 14, wherein a convex rib is provided on a side of the conductive housing facing the ground contact member, and the convex rib is pressed against the ground contact member.

16. The cable connector according to any one of claims 3 to 15, wherein the conductive housing is further provided with an accommodating groove, the accommodating groove is located in a side of all the shielding cavities opposite to the first avoidance opening, and each cable is further partially located in the accommodating groove;
the cable connector further comprises a thrust member, the thrust member is disposed in the accommodating groove of the conductive housing, and an outer edge of the thrust member is connected to an inner wall of the accommodating groove; and
the thrust member is provided with a plurality of third avoidance openings, each third avoidance opening is configured to allow a corresponding cable to pass through, and a width of each third avoidance opening is smaller than a cross-sectional size of each signal terminal.

17. A cable connector assembly, comprising a plurality of cables and the cable connector according to any one of claims 1 to 16, wherein
in the cable connector, each signal terminal of a signal pair unit is electrically connected to a corresponding cable.

18. The cable connector assembly according to claim 17, wherein the cable comprises a cable core, an insulating layer, and a conductive layer that are sequentially disposed from inside out; and
one end of the cable core is electrically connected to a corresponding signal terminal, and the conductive layer is electrically connected to a conductive housing of the cable connector.

19. The cable connector assembly according to claim 18, wherein the cable further comprises a cable insulator; and
the cable insulator is disposed on a periphery of one end of the cable core connected to the signal terminal.

20. A circuit board assembly, comprising a circuit board and at least one cable connector assembly according to any one of claims 17 to 19, wherein
a signal terminal of the cable connector assembly is in electrical contact with a corresponding pin on the circuit board, and a first end of the signal terminal is at least partially perpendicular to the circuit board.

21. The circuit board assembly according to claim 20, wherein a pad is provided on a pin on the circuit board, and one end of the signal terminal is in electrical contact with the pad.

22. The circuit board assembly according to claim 21, wherein the pad is provided with a groove, and the first end of the signal terminal is located in the groove.

23. The circuit board assembly according to any one of claims 20 to 22, wherein the circuit board comprises any one of a substrate and a chip.

24. An electronic device, comprising the circuit board assembly according to any one of claims 20 to 23.
